(19) Europäisches Patentamt
European Patent Office
Office européen des brevets

(11) **EP 4 524 286 A1**

(12) **EUROPEAN PATENT APPLICATION**
published in accordance with Art. 153(4) EPC

(43) Date of publication:
**19.03.2025 Bulletin 2025/12**

(21) Application number: **23803869.9**

(22) Date of filing: **11.05.2023**

(51) International Patent Classification (IPC):
***C23C 16/18*** *(2006.01)* ***C23C 16/40*** *(2006.01)*
***C23C 16/455*** *(2006.01)*

(52) Cooperative Patent Classification (CPC):
**C07F 7/00; C23C 16/18; C23C 16/40; C23C 16/455; C23C 16/52**

(86) International application number:
**PCT/KR2023/006432**

(87) International publication number:
**WO 2023/219446 (16.11.2023 Gazette 2023/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **13.05.2022 KR 20220058979**

(71) Applicant: **Up Chemical Co., Ltd.**
**Pyeongtaek-si, Gyeonggi-do 17749 (KR)**

(72) Inventors:
- **KIM, Byung Kwan**
  **Pyeongtaek-si, Gyeonggi-do 17749 (KR)**
- **KIM, Jin Sik**
  **Pyeongtaek-si, Gyeonggi-do 17749 (KR)**
- **PARK, Myeong Ho**
  **Pyeongtaek-si, Gyeonggi-do 17749 (KR)**
- **AHN, Sung Woo**
  **Pyeongtaek-si, Gyeonggi-do 17749 (KR)**
- **YU, Da Som**
  **Pyeongtaek-si, Gyeonggi-do 17749 (KR)**
- **CHOI, Jun Hwan**
  **Pyeongtaek-si, Gyeonggi-do 17749 (KR)**

(74) Representative: **Dehns**
**10 Old Bailey**
**London EC4M 7NG (GB)**

(54) **FILM DEPOSITING COMPOSITION INCLUDING GROUP 4 METAL ELEMENT-CONTAINING PRECURSOR COMPOUND AND METHOD FOR FORMING FILM USING SAME**

(57) The present invention relates to a film depositing composition including a Group 4 metal element-containing precursor compound and a method for forming a Group 4 metal element-containing film using same. The use of the film depositing composition including a Group 4 metal element-containing precursor compound of the present invention achieves self-limiting film growth of ALD over a wide temperature range from low to high temperatures, enabling the formation of a Group 4 metal element-containing film for various purposes at various process temperatures. Particularly, according to the method for forming a Group 4 metal element-containing film of this invention, the growth per cycle (GPC) of ALD is consistent over a broad temperature range, thus making it possible to form a Group 4 metal element-containing film of uniform thickness even on surfaces with large aspect ratio trenches. Thus, the method can be advantageously utilized in manufacturing various semiconductor devices, such as DRAM, 3D NAND flash memory, and the like.

[Fig. 3]

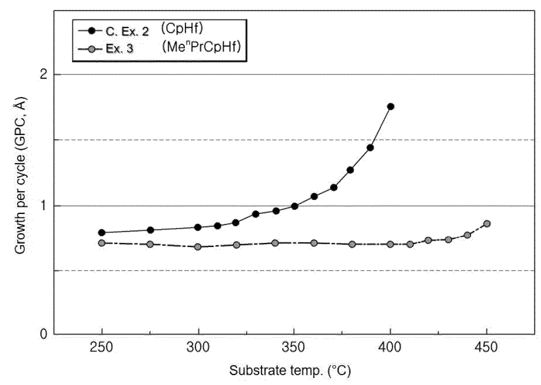




Processed by Luminess, 75001 PARIS (FR)

## Description

Technical Field

The present invention relates to a composition for film deposition comprising a group IV metal element-containing precursor compound and to a method for forming a film using the same.

Background Art

A Group 4 metal element-containing film, especially a Group 4 metal oxide film having a high dielectric constant, is one of the thin films essential for driving non-memory semiconductor devices such as logic devices, as well as memory semiconductor devices such as DRAM, flash memory, resistive memory (ReRAM), ferroelectric memory (FeRAM), and phase change memory (PCRAM).

In particular, such a Group 4 metal element-containing film is used in the state-of-the-art technology of organic light emitting diodes (OLEDs) in the display field and in a gate insulation film, a capacitor high-k dielectric film, and the like in memory devices.

Meanwhile, products having a complex shape such as a high aspect ratio and a three-dimensional structure are variously developed in the semiconductor field and non-semiconductor field. As a result, there is a demand for a composition for film deposition comprising a group IV metal element-containing precursor compound for forming a Group 4 metal element-containing film that can be used for atomic layer deposition (ALD), which is suitable for process temperatures for various application fields and can overcome a high step ratio.

[Prior art documents]

[Non-patent documents]

J. Niinistö et al., "Novel mixed alkylamido-cyclopentadienyl precursors for ALD of ZrO2 thin films" Journal of Materials Chemistry 2008, 18 (43), 5243. https://doi.org/10.1039/b810922b

## Disclosure of Invention

### Technical Problem

A technical problem to be solved by the present invention is to provide a method of forming a Group 4 metal element-containing film in which the film growth per ALD gas supply cycle, growth per cycle (GPC), does not vary in a wide temperature range, and a uniform film with excellent step coverage can be achieved even on a substrate having a complex shape.

Another technical problem to be solved by the present invention is to provide a composition for film deposition comprising a Group 4 metal element-containing precursor compound having a specific structure.

However, the problems to be solved by the present invention are not limited to those mentioned above, and other problems not mentioned will be clearly understood by those skilled in the art from the following description.

### Solution to Problem

In order to accomplish the above object, the present invention provides a method for forming a Group 4 metal element-containing film, which comprises subjecting a composition for film deposition comprising a Group 4 metal element-containing precursor compound represented by the following Formula 1 to a reaction with a reaction gas to form a Group 4 metal element-containing film on a substrate:

[Formula 1]

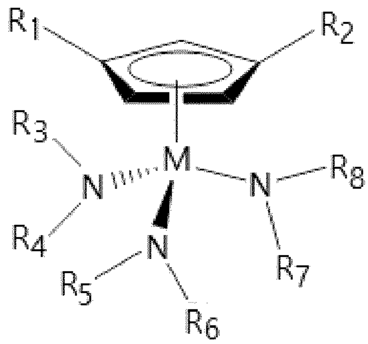

In Formula 1, M is Zr or Hf, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

In addition, there is provided a composition for film deposition, which comprises a Group 4 metal element-containing precursor compound represented by the above Formula 1.

## Advantageous Effects of Invention

As the composition for film deposition comprising a Group 4 metal element-containing precursor compound of the present invention is used, the self-limiting film growth of ALD can be achieved over a wide temperature range, especially at high temperatures; thus, it is possible to form a Group 4 metal element-containing film for various applications at various process temperatures.

In particular, according to the method for forming a Group 4 metal element-containing film of the present invention, since GPC does not vary in a wide temperature range of not only low temperatures but also high temperatures, it is possible to form a Group 4 metal element-containing film with a uniform thickness even on a surface having grooves with a large aspect ratio. Thus, it can be advantageously used to manufacture various semiconductor devices such as DRAM and 3D NAND flash memory.

## Brief Description of Drawings

Fig. 1 is a graph for comparing $^1$H-NMR spectra of hafnium (Hf)-containing precursor compounds prepared according to Example 3 of the present invention and Comparative Example 5.

Fig. 2 is a graph showing GPC at a temperature in the range of 250°C to 400°C when a zirconium (Zr)-containing film is deposited using the composition for film deposition of Example 1 of the present invention and Comparative Examples 1, 3, and 4.

Fig. 3 is a graph showing GPC at a temperature in the range of 250°C to 450°C when a hafnium (Hf)-containing film is deposited using the composition for film deposition of Example 3 of the present invention and Comparative Example 2.

Fig. 4 shows transmission electron microscope (TEM) images confirming the step coverage of films deposited at 300°C using each of the compositions for film deposition of Example 1 of the present invention and Comparative Examples 1, 3, and 4.

Fig. 5 shows transmission electron microscope (TEM) images confirming the step coverage of films deposited at 340°C and 360°C using each of the compositions for film deposition of Example 1 of the present invention and Comparative Examples 3 and 4.

Fig. 6 shows transmission electron microscope (TEM) images confirming the step coverage of films deposited at 350°C and 400°C using each of the compositions for film deposition of Example 3 of the present invention and Comparative Example 2.

## Best Mode for Carrying out the Invention

Hereinafter, the present application will be described in more detail.

The advantages and features of the present invention and the methods of achieving them will become apparent

with reference to the embodiments described hereinafter. However, the present invention is not limited to the embodiments described below, but may be embodied in various different forms. These embodiments are provided so that the disclosure of the present invention will be thorough and complete, and will fully convey the scope of the invention to those skilled in the art. The invention is defined by only the scope of the claims.

In addition, in the present specification, in the case where an element is mentioned to be formed "on" another element, it means not only that one element is directly formed "on" another element, but also that other element(s) is interposed between them.

In the present specification, when a part is referred to as "comprising" an element, it is to be understood that the part may comprise other elements as well, rather than exclude other elements, unless otherwise indicated.

All numbers and expressions related to the quantities of components, reaction conditions, and the like used herein are to be understood as being modified by the term "about," unless otherwise indicated.

In the present specification, each of the terms "film" and "thin film" refers to both "film" and "thin film," unless otherwise specified.

In the present specification, the term "alkyl" or "alkyl group" covers linear or branched alkyl groups and all possible isomers thereof. For example, the alkyl or alkyl group covers not only a methyl group (Me), an ethyl group (Et), a normal propyl group ($^n$Pr), an isopropyl group ($^i$Pr), a normal butyl group ($^n$Bu), an isobutyl group ($^i$Bu), a tert-butyl group (tert-Bu, $^t$Bu), sec-butyl group ($^{sec}$Bu), and the like, but also isomers thereof, and the like, but it is not limited thereto.

**[Method for forming a Group 4 metal element-containing film]**

According to an embodiment of the present invention, there is provided a method for forming a Group 4 metal element-containing film, which comprises subjecting a composition for film deposition comprising a Group 4 metal element-containing precursor compound represented by the following Formula 1 to a reaction with a reaction gas to form a Group 4 metal element-containing film on a substrate:

[Formula 1]

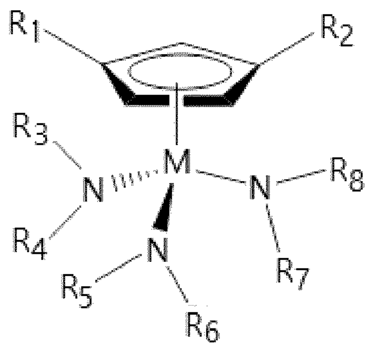

In Formula 1, M is Zr or Hf, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

As the composition for film deposition comprising a Group 4 metal element-containing precursor compound represented by the above Formula 1 is used in the method for forming a Group 4 metal element-containing film according to an embodiment of the present invention, it is possible to form a Group 4 metal element-containing film by chemical vapor deposition (CVD) or ALD with with a constant GPC in a wide temperature range including high temperatures as well as low temperatures.

In particular, the Group 4 metal element-containing precursor compound represented by Formula 1 may be in a structure of a single composition. Here, the term "single composition" refers to a substance that does not contain structural isomers. It may not mean a 100% pure substance. For example, it may contain impurities of 5% or less. In addition, the term "impurities" may refer to all substances except for the Group 4 metal element-containing precursor compound represented by Formula 1.

Specifically, the Group 4 metal element-containing precursor compound represented by Formula 1 may be in a structure of a single composition (single substance structure) when analyzed by a $^1$H-NMR spectrum, in which structural isomers or mixtures thereof are not contained, and the content of impurities is, for example, 5% or less, 3% or less, 2% or less, 1% or less, or 0.5% or less. Thus, the Group 4 metal element-containing precursor compound represented by Formula 1 has a high purity of 95% or more, is present in a liquid state at room temperature, which is advantageous in the

preparation process, and has excellent thermal stability; thus, it is possible to easily form various Group 4 metal element-containing films.

In addition, it is possible to form a uniform film with excellent coverage even on a substrate having patterns (grooves) on its surface, a porous substrate, a plastic substrate, or a substrate having a complex shape in a three-dimensional structure, whereby it is possible to provide a Group 4 metal element-containing film of high quality. Thus, it has technical significance in that it can be advantageously used in various applications in the field of semiconductor devices, as well as it can exhibit excellent characteristics.

Specifically, according to an embodiment of the present invention, when the composition for film deposition comprising the Group 4 metal element-containing precursor compound is used to form a Group 4 metal element-containing film, specifically, a zirconium (Zr)-containing film or a hafnium (Hf)-containing film, by ALD at a temperature of, for example, 150°C to 500°C, 200°C to 500°C, 200°C to 450°C, 250°C to 450°C, 250°C to 400°C, 250°C to 380°C, 250°C to 360°C, 250°C to 350°C, or 250°C to 340°C, the change in GPC (ΔGPC, %) is near zero, or as small as, for example, 30% or less, less than 30%, 29% or less, 25% or less, 20% or less, 18% or less, 16% or less, 15% or less, 13% or less, 12% or less, 11% or less, less than 11%, 10% or less, 9% or less, 8% or less, 7% or less, 6% or less, 5% or less, or 4% or less.

The Group 4 metal element-containing precursor compound represented by Formula 1 is described in detail in the section of "Composition for film deposition" below.

The method for forming a Group 4 metal element-containing film according to an embodiment of the present invention comprises providing at least a portion of the substrate to a reaction chamber (first step); supplying the composition for film deposition in a gaseous state to the reaction chamber (second step); and feeding the reaction gas into the reaction chamber (third step).

In addition, according to the method for forming a Group 4 metal element-containing film, the gas supply cycle comprising the second step and the third step may be repeated multiple times, for example, several times, tens of times, hundreds of times, or thousands of times to form a group 4 metal element-containing film having a desired thickness.

In addition, it may further comprise, between the second step and the third step, supplying an inert gas such as argon (Ar) gas or nitrogen ($N_2$) gas to the reaction chamber to remove the composition (gas) for film deposition remaining in the reaction chamber. In addition, it may further comprise, after the third step, supplying an inert gas such as argon (Ar) gas or nitrogen ($N_2$) gas to the reaction chamber to remove the reaction gas remaining in the reaction chamber.

Specifically, the method for forming a Group 4 metal element-containing film may comprise providing at least a portion of the substrate to a reaction chamber (first step).

The substrate may be one selected from conventional semiconductor wafers, compound semiconductor wafers, and plastic substrates (PI, PET, PES, and PEN), but it may not be limited thereto. In addition, a substrate having holes or grooves may be used, and a porous substrate having a large surface area may be used.

In particular, it is possible to produce an excellent effect of forming a Group 4 metal element-containing film having a uniform thickness of several nanometers (nm) to several micrometers (μm) even on a substrate having patterns (grooves) on its surface, a porous substrate, or a plastic substrate in various temperature ranges of, for example, 150°C to 500°C; and uniformly forming a Group 4 metal element-containing film on a substrate, covering the deepest surface of fine patterns (grooves) and the upper surface having at least one of the fine grooves having an aspect ratio of 1 or more, for example, about 1 to 50 or more and a width of 1 μm or less, for example, about 1 μm to 10 nm or less.

The method for forming a Group 4 metal element-containing film may comprise supplying the composition for film deposition comprising a Group 4 metal element-containing precursor compound in a gaseous state to the reaction chamber (second step).

The composition for film deposition comprising a Group 4 metal element-containing precursor compound is delivered in a gaseous state to form a Group 4 metal element-containing oxide film on the substrate. In addition, a composition for film deposition containing other elements may be used together with the composition for film deposition to form a Group 4 metal element-containing composite metal oxide film or nano-laminate, for example, a film of Zr-Si-O, Hf-Si-O, Hf-Zr-O, $ZrO_2/Al_2O_3/ZrO_2$, or $ZrO_2/Al_2O_3/TiO_2$.

Specifically, when the composition for film deposition comprising a Group 4 metal element-containing precursor compound is supplied to the reaction chamber, the composition for film deposition comprising a Group 4 metal element-containing precursor compound can be delivered onto the substrate using a transport gas or a diluent gas to form a Group 4 metal element-containing film at a deposition temperature of 150°C to 500°C.

In addition, it is preferable to use a single or mixed gas selected from the group consisting of argon (Ar), nitrogen ($N_2$), helium (He), and hydrogen ($H_2$) as the transport gas or diluent gas.

In addition, the method of delivering the composition for film deposition comprising a Group 4 metal element-containing precursor compound into the reaction chamber may be at least one method selected from the group consisting of a bubbling method in which the composition for film deposition comprising a Group 4 metal element-containing precursor compound is forcibly vaporized using a transport gas or a diluent gas; a liquid delivery system (LDS) method for supplying it in a liquid phase at room temperature to be vaporized through a vaporizer; a vapor flow control (VFC) method for directly supplying the composition for film deposition comprising the precursor compound using its vapor pressure; and

a bypass method. In addition, a method of supplying the composition for film deposition in a gaseous state in chemical vapor deposition (CVD) or ALD can be applied to the present invention.

The method for forming a Group 4 metal element-containing film according to an embodiment of the present invention may comprise feeding the reaction gas into the reaction chamber (third step).

According to the method for forming a Group 4 metal element-containing film, in order to deposit a Group 4 metal element-containing oxide film ($ZrO_2$, $HfO_2$) or a Group 4 metal element-containing composite metal oxide film ($ZrSiO_x$, $ZrAlO_x$, $ZrHfO_x$, $ZrHfSiO_x$, $ZrHfAlO_x$, $ZrHfSiAlO_x$, ZrON, or the like), at least one selected from the group consisting of water vapor ($H_2O$), oxygen ($O_2$), oxygen plasma ($O_2$ plasma), nitric oxide (NO, $N_2O$), nitric oxide plasma ($N_2O$ plasma), oxygen nitrate ($N_2O_2$), hydrogen peroxide ($H_2O_2$), and ozone ($O_3$) may be used as a reaction gas.

In addition, in order to deposit a Group 4 metal element-containing nitride film or a Group 4 metal element-containing composite metal nitride film, at least one selected from the group consisting of ammonia ($NH_3$), ammonia plasma ($NH_3$ plasma), hydrazine ($N_2H_4$), and nitrogen plasma ($N_2$ plasma) may be used during deposition.

According to an embodiment of the present invention, the composition for film deposition comprising a group 4 metal element-containing precursor compound is delivered in a gaseous state to form at least one selected from the group consisting of a Group 4 metal element-containing nitride film, a Group 4 metal element-containing carbide film, and a Group 4 metal element-containing composite metal film on a substrate.

for example, the composition for film deposition comprising a group 4 metal element-containing precursor compound is delivered in a gaseous state to form a Group 4 metal element-containing film, specifically, a Group 4 metal element-containing oxide film, a Group 4 metal element-containing composite metal oxide film, a Group 4 metal element-containing nitride film, or a Group 4 metal element-containing composite metal nitride film, on the surface of at least a part of the substrate through CVD or ALD.

The deposition method of a Group 4 metal element-containing film may use any methods and/or apparatuses known in the art to which the present invention pertains; if necessary, it may be carried out using one or more additional reaction gases or the like.

The deposition method of a Group 4 metal element-containing film may be carried out by CVD, for example, organometallic chemical vapor deposition (MOCVD), or ALD. The MOCVD or ALD may be carried out using a deposition apparatus, deposition conditions, and reaction gases known in the art.

**[Group 4 metal element-containing film]**

According to an embodiment of the present invention, there is provided a Group 4 metal element-containing film formed by the method for forming a Group 4 metal element-containing film.

The Group 4 metal element-containing film may have a thickness of about 1 nanometer (nm) to several micrometers ($\mu$m) and may be variously applied depending on the application purposes. Specifically, the Group 4 metal element-containing film may be formed in a thickness range of 1 nm to 500 nm.

The Group 4 metal element-containing film may be formed on a substrate (or board).

The substrate is as described above.

The Group 4 metal element-containing film according to an embodiment of the present invention is of high quality with stable and consistent physical properties as well as excellent step coverage by using the composition comprising a Group 4 metal element-containing precursor compound having a specific structure for film deposition.

The Group 4 metal element-containing film may be at least one selected from the group consisting of a Group 4 metal element-containing oxide film, a Group 4 metal element-containing composite metal oxide film, a Group 4 metal element-containing nitride film, and a Group 4 metal element-containing composite metal nitride film. Specifically, the Group 4 metal element-containing film may comprise at least one selected from the group consisting of a Group 4 metal element-containing oxide film and a Group 4 metal element-containing composite metal oxide film.

In addition, the Group 4 metal element-containing film may comprise a nano-laminate, for example, a film of Zr-Si-O, Hf-Si-O, Hf-Zr-O, $ZrO_2/Al_2O_3/ZrO_2$, or $ZrO_2/Al_2O_3/TiO_2$.

In addition, the Group 4 metal element-containing film may be very excellent in step coverage.

For example, when an oxide film or a nitride film having a thickness of about 5 nm to 20 nm is formed in a groove having an aspect ratio of 10:1 or more by ALD at a process temperature of about 300°C or higher using the composition for film deposition according to an embodiment of the present invention, the thickness deviation calculated by measuring the film thickness of the top, middle, and bottom is very small, indicating very excellent step coverage (%). In such an event, the step coverage refers to the ratio of the bottom thickness to the top thickness (bottom thickness/top thickness) $\times$ 100)).

Specifically, the composition for film deposition according to an embodiment of the present invention may have a step coverage of 80% or more, 82% or more, 85% or more, 90% or more, 92% or more, 93% or more, 95% or more, or 96% or more.

In particular, when an oxide film or a nitride film is formed in a groove having a large aspect ratio, there is difficulty in forming a film with a constant thickness since the thickness deviation of the film formed at the top and bottom is large.

However, the composition for film deposition according to an embodiment of the present invention can form a film having a uniform thickness even in a groove having a large aspect ratio. Thus, it is more effective in manufacturing various semiconductor devices such as DRAM and 3D NAND flash memory.

More specifically, when a hafnium (Hf)-containing oxide film having a thickness of about 6 to 7 nm is formed on a substrate, in which a titanium nitride (TiN) film is formed in grooves having an aspect ratio of 11:1, by ALD at a process temperature of about 350°C and about 400°C using the composition for film deposition according to an embodiment of the present invention, the step coverage (%) calculated by measuring the thickness of the hafnium (Hf)-containing oxide film in the transmission electron microscope (TEM) photographs of the top, middle, and bottom of the grooves shown in Fig. 6 can be very excellent with a specific value or more.

According to an embodiment, when a Group 4 metal element-containing film is formed on a substrate having an aspect ratio of 11:1 at a temperature of about 350°C, the Group 4 metal element-containing film, for example, a hafnium (Hf)-containing oxide film may have a step coverage (%) of, for example, 80% or more, 82% or more, 85% or more, 90% or more, 92% or more, 93% or more, 95% or more, or 96% or more.

In addition, when a Group 4 metal element-containing film is formed on a substrate having an aspect ratio of 11:1 at a temperature of about 400°C, the Group 4 metal element-containing film, for example, a hafnium (Hf)-containing oxide film may have a step coverage (%) of, for example, 85% or more, 90% or more, 92% or more, 93% or more, 95% or more, 96% or more, 97% or more, or 98% or more.

In addition, when a zirconium (Zr)-containing oxide film having a thickness of about 12 to 15 nm is formed on a substrate, in which a silicon oxide film is formed in grooves having an aspect ratio of 20:1, by ALD at a process temperature of about 340°C and about 360°C using the composition for film deposition according to an embodiment of the present invention, the step coverage (%) calculated by measuring the thickness of the zirconium (Zr)-containing oxide film in the transmission electron microscope (TEM) photographs of the top, middle, and bottom of the grooves shown in Figs. 4 and 5 can be very excellent with a specific value or more.

According to an embodiment, when a Group 4 metal element-containing film is formed on a substrate having an aspect ratio of 20:1 at a temperature of about 300°C, the Group 4 metal element-containing film, for example, a zirconium (Zr)-containing oxide film may have a step coverage (%) of, for example, 80% or more, 82% or more, 85% or more, 90% or more, 92% or more, 93% or more, 95% or more, or 96% or more.

In addition, when a Group 4 metal element-containing film is formed on a substrate having an aspect ratio of 20:1 at a temperature of about 340°C, the Group 4 metal element-containing film, for example, a zirconium (Zr)-containing oxide film may have a step coverage (%) of, for example, 80% or more, 82% or more, 85% or more, 90% or more, 92% or more, 93% or more, 95% or more, or 96% or more.

In addition, when a Group 4 metal element-containing film is formed on a substrate having an aspect ratio of 20:1 at a temperature of about 360°C, the Group 4 metal element-containing film, for example, a zirconium (Zr)-containing oxide film may have a step coverage (%) of, for example, 85% or more, 90% or more, 92% or more, 93% or more, 95% or more, 96% or more, 97% or more, 98% or more, or 99% or more.

If the Group 4 metal element-containing film has a step coverage (%) satisfying the above range, a high step ratio and fine thickness control are possible, so that it can be advantageously used to manufacture various semiconductor devices such as DRAM and 3D NAND flash memory.

**[Composition for film deposition]**

The composition for film deposition according to an embodiment of the present invention may comprise a Group 4 metal element-containing precursor compound represented by the following Formula 1.

[Formula 1]

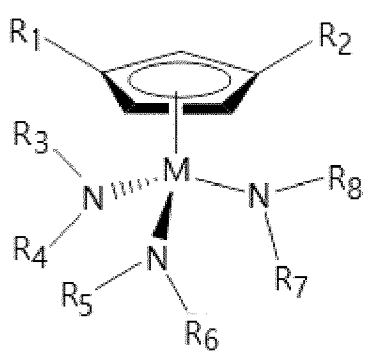

In Formula 1, M is Zr or Hf, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

As the composition for film deposition according to an embodiment of the present invention comprises the compound represented by Formula 1, when a film is deposited in a wide temperature range, for example, a process temperature of 250°C to 400°C, the change in GPC (ΔGPC, %) with respect to temperature as represented by the following Equation A may be as small as to be 30% or lower, less than 30%, 25% or lower, 20% or lower, 18% or lower, 15% or lower, 13% or lower, 12% or lower, 11% or lower, less than 11%, 10% or lower, 8% or lower, 7% or lower, 6% or lower, or 5% or lower.

[Equation A]

$$\text{Change in growth per cycle (GPC) } (\Delta\text{GPC, \%}) = \frac{\text{GPC}_{temp} - \text{GPC}_{250}}{\text{GPC}_{250}} \times 100$$

In Equation A, $GPC_{250}$ is the GPC at 250°C, and $GPC_{temp}$ is the GPC at a process temperature.

Specifically, according to an embodiment of the present invention, when a film is deposited at a process temperature of, for example, 250°C to 320°C using the composition for film deposition, the change in GPC (ΔGPC, %) with respect to temperature may be as small as to be, for example, 30% or lower, less than 30%, 25% or lower, 20% or lower, 10% or lower, 8% or lower, 7% or lower, 6% or lower, 5% or lower, 4% or lower, 3% or lower, 2% or lower, 1.5% or lower, or 1% or lower.

According to another embodiment of the present invention, when a film is deposited at a process temperature of, for example, 250°C to 340°C using the composition for film deposition, the change in GPC (ΔGPC, %) with respect to temperature may be as small as to be, for example, 30% or less, less than 30%, 25% or less, 20% or less, less than 20%, 18% or less, 15% or less, 13% or less, 12% or less, 11% or less, less than 11%, 10% or less, 8% or less, 7% or less, or 6% or less.

According to another embodiment of the present invention, when a film is deposited at a process temperature of, for example, 250°C to 360°C using the composition for film deposition, the change in GPC (ΔGPC, %) with respect to temperature may be as small as to be, for example, 30% or less, less than 30%, 25% or less, 20% or less, 18% or less, 15% or less, 13% or less, 12% or less, 11% or less, less than 11%, 10% or less, or 9% or less.

According to another embodiment of the present invention, when a film is deposited at a process temperature of, for example, 250°C to 380°C using the composition for film deposition, the change in GPC (ΔGPC, %) with respect to temperature may be as small as to be, for example, 30% or less, less than 30%, 25% or less, 20% or less, 18% or less, 15% or less, 13% or less, or 12% or less.

According to another embodiment of the present invention, when a film is deposited at a process temperature of, for example, 300°C to 360°C using the composition for film deposition, the change in GPC (ΔGPC, %) with respect to temperature may be as small as to be 30% or less, less than 30%, 25% or less, 20% or less, 18% or less, 15% or less, 13% or less, 12% or less, 11% or less, less than 11%, 10% or less, 8% or less, 7% or less, 6% or less, or 5% or less. Here, in Equation A, it may be calculated using $GPC_{300}$ (i.e., GPC at 300°C) instead of $GPC_{250}$.

According to another embodiment of the present invention, when a film is deposited at a process temperature of, for example, 330°C to 390°C using the composition for film deposition, the change in GPC (ΔGPC, %) with respect to temperature may be as small as to be, for example, 30% or less, less than 30%, 25% or less, 20% or less, 18% or less, 15% or less, 13% or less, 12% or less, 11% or less, less than 11%, 8% or less, 7% or less, 6% or less, or 5% or less. Here, in Equation A, it may be calculated using $GPC_{330}$ (i.e., GPC at 330°C) instead of $GPC_{250}$.

According to another embodiment of the present invention, when a film is deposited at a process temperature of, for example, 360°C to 400°C using the composition for film deposition, the change in GPC (ΔGPC, %) with respect to temperature may be as small as to be, for example, 30% or less, less than 30%, 25% or less, 20% or less, 18% or less, 15% or less, 13% or less, 12% or less, 11% or less, less than 11%, 8% or less, 7% or less, 6% or less, 5% or less, 4% or less, or 3% or less. Here, in Equation A, it may be calculated using $GPC_{360}$ (i.e., GPC at 360°C) instead of $GPC_{250}$.

More specifically, the composition for film deposition according to an embodiment of the present invention comprises a Group 4 metal element-containing precursor compound represented by the following Formula 2. When a zirconium (Zr)-containing film is deposited by ALD at a process temperature of 250°C to 380°C, the change in GPC (ΔGPC, %) with respect to temperature as represented by the above Equation A may be as small as, for example, 30% or lower, less than 30%, 25% or lower, 20% or lower, 18% or lower, 15% or lower, 13% or lower, 12% or lower, 11% or lower, less than 11%, 10% or lower, 8% or lower, 7% or lower, 6% or lower, 5% or lower, or 4% or lower.

[Formula 2]

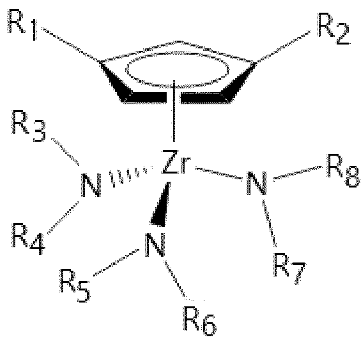

In Formula 2, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

In addition, when the compound represented by Formula 2 is used to form a film at a process temperature of, for example, 250°C to 340°C, 250°C to 360°C, 250°C to 380°C, 300°C to 360°C, 330°C to 390°C, or 360°C to 400°C, the change in GPC (ΔGPC, %) with respect to temperature is as small as 30% or less, respectively, as described above in detail. That is, since the GPC does not vary significantly in a wide temperature range of not only low temperatures but also high temperatures, a group 4 metal element-containing film having a uniform thickness can be formed even on a surface having grooves with a large aspect ratio.

The Group 4 metal element-containing precursor compound may be a compound represented by any one of the following Formulae 2-1 to 2-3.

[Formula 2-1]

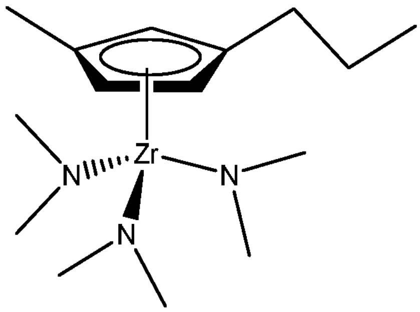

[Formula 2-2]

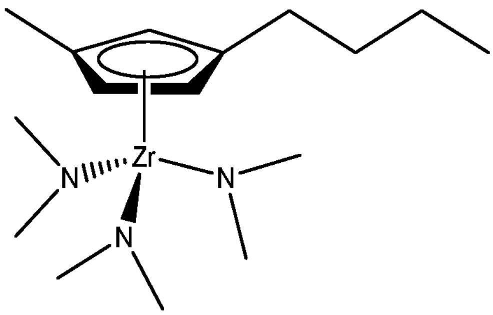

and

[Formula 2-3]

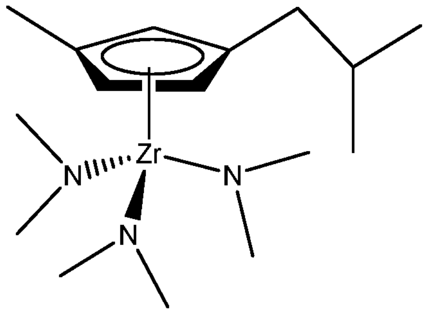

In addition, the composition for film deposition comprises a Group 4 metal element-containing precursor compound represented by the following Formula 3. When a hafnium (Zr)-containing film is deposited by ALD at a process temperature of 250°C to 400°C, the change in GPC (ΔGPC, %) with respect to temperature as represented by the above Equation A may be as small as, for example, 30% or lower, less than 30%, 25% or lower, 20% or lower, 18% or lower, 15% or lower, 13% or lower, 12% or lower, 11% or lower, less than 11%, 10% or lower, 8% or lower, 7% or lower, 6% or lower, 5% or lower, 4% or lower, 3% or lower, 1% or lower, less than 1%, 0% or lower, or less than 0%.

[Formula 3]

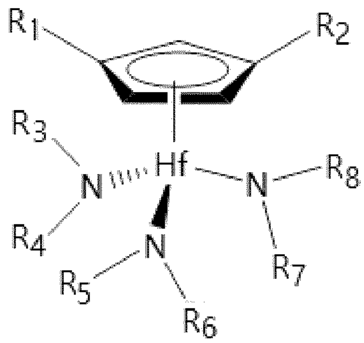

In Formula 3, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

In addition, when the compound represented by Formula 3 is used to form a film at a process temperature of, for example, 250°C to 340°C, 250°C to 360°C, 250°C to 380°C, 250°C to 400°C, 250°C to 420°C, 250°C to 430°C, 300°C to 360°C, 330°C to 390°C, or 360°C to 400°C, the change in GPC (ΔGPC, %) with respect to temperature is as small as 30% or less, respectively, as described above in detail. That is, since the GPC does not vary significantly in a wide temperature range of not only low temperatures but also high temperatures, a group 4 metal element-containing film having a uniform thickness can be formed even on a surface having grooves with a large aspect ratio.

The Group 4 metal element-containing precursor compound may be a compound represented by any one of the following Formulae 3-1 to 3-3.

[Formula 3-1]

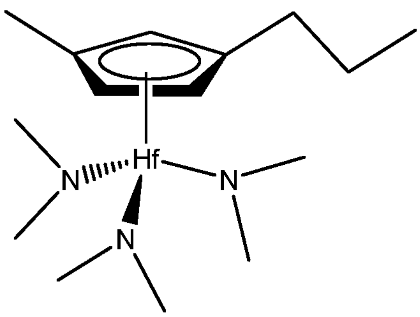

[Formula 3-2]

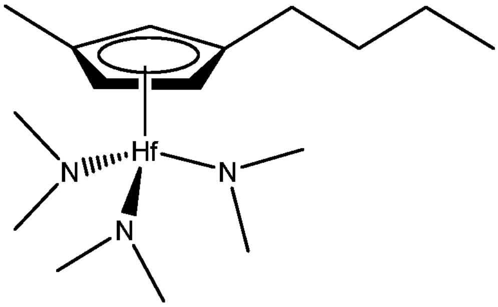

and

[Formula 3-3]

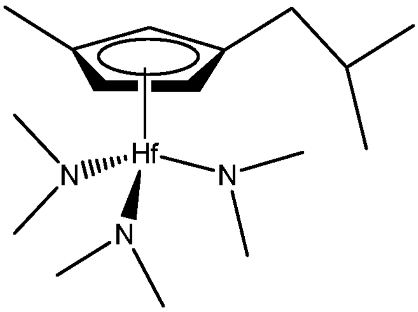

The change in GPC (ΔGPC, %) with respect to temperature may be measured in a unit of 1°C to 50°C during film deposition. Specifically, the change in GPC (ΔGPC, %) with respect to temperature may be measured in a unit of, for example, 5°C, 10°C, 15°C, 20°C, 25°C, or 30°C.

Meanwhile, when the Group 4 metal element-containing precursor compound is used to form a Group 4 metal element-containing film by ALD using ozone ($O_3$) as a reaction gas, it is possible to achieve GPC of 0.5 to 1.0 Å/cycle, 0.6 to 1.0 Å/cycle, 0.7 to 1.0 Å/cycle, 0.8 to 1.0 Å/cycle, 0.6 to 0.9 Å/cycle, 0.7 to 0.9 Å/cycle, 0.8 to 0.9 Å/cycle, 0.6 to 0.8 Å/cycle, or 0.7 to 0.8 Å/cycle, at 150°C to 400°C.

For example, when the Group 4 metal element-containing precursor compound is a Group 4 metal element-containing precursor compound represented by Formula 2 and used to form a zirconium (Zr)-containing film by ALD using ozone ($O_3$) as a reaction gas, the GPC may be 0.5 to 0.9 Å/cycle, 0.6 to 0.9 Å/cycle, 0.7 to 0.9 Å/cycle, or 0.8 to 0.9 Å/cycle, at 150°C to 400°C, for example, 200°C to 400°C or 250°C to 400°C.

As another example, when the Group 4 metal element-containing precursor compound is a Group 4 metal element-containing precursor compound represented by Formula 3 and used to form a hafnium (Hf)-containing film by ALD using ozone ($O_3$) as a reaction gas, the GPC may be 0.5 to 0.9 Å/cycle, 0.6 to 0.9 Å/cycle, 0.7 to 0.9 Å/cycle, 0.6 to 0.8 Å/cycle, or 0.7 to 0.8 Å/cycle, at 150°C to 410°C, for example, 150°C to 400°C or 250°C to 400°C.

As the Group 4 metal element-containing precursor compound has a specific structure of Formula 1, for example, Formula 2 or Formula 3, and a composition for film deposition comprising the precursor compound is used, a Group 4 metal element-containing film can be uniformly formed by ALD in a wide temperature range.

The Group 4 metal element-containing precursor compound represented by Formula 1, for example, Formula 2 or Formula 3, can be synthesized by using an alkylsubstituted cyclopentadiene instead of cyclopentadiene ($C_5H_6$) in the synthesis method of a generally known $CpZr(NMe_2)_3$ compound or $CpHf(NMe_2)_3$ compound.

**Mode for the Invention**

Hereinafter, the present invention will be described in detail with reference to examples. The following examples are only illustrative of the present invention, and the scope of the present invention is not limited thereto.

## Preparation Example

### <Preparation Example 1> Preparation of 1-methyl-3-propylcyclopenta-1,3-diene

[Formula 4-1]

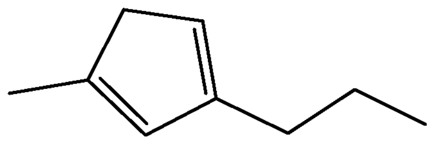

A flame-dried, 1-liter Schlenk flask was charged with about 27 g (about 0.281mole) of 3-methyl-2-cyclopenten-1-one (MCPO) and about 100 ml of tetrahydrofuran (THF, $C_4H_8O$) at room temperature. About 40.4 g (about 0.393 mole) of n-propyl magnesium chloride ($^{n}PrMgCl$) was slowly dropwise added to the flask, and then the reaction solution was stirred at room temperature for about 4 hours.

About 33.7 g (about 0.562 mole) of acetic acid ($CH_3COOH$) mixed with about 200 ml of distilled water (DI Water) was slowly dropwise added to the flask, and then the reaction solution was stirred at room temperature for one day. The water layer was removed using a separatory funnel. Then, about 14.9 g (about 0.140 mole) of sodium carbonate ($Na_2CO_3$) mixed with about 150 ml of distilled water (DI Water) was slowly dropwise added, and the reaction solution was stirred at room temperature for about 2 hours. The water layer was removed using a separatory funnel. Then, moisture was removed using magnesium sulfate ($MgSO_4$). The solvent was removed under a reduced pressure, and the resultant was distilled under a reduced pressure to obtain about 17 g (yield 49.5%) of 1-methyl-3-n-propylcyclopenta-1,3-diene represented by Formula 4-1 as a colorless transparent liquid compound, which was used to synthesize a composition for film deposition.

### <Preparation Example 2> Preparation of 3-butyl-1-methylcyclopenta-1,3-diene

[Formula 4-2]

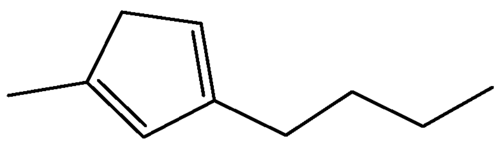

The same method as in Preparation Example 1 was used, except that n-butyl magnesium chloride ("BuMgCl) was used instead of n-propyl magnesium chloride ($^{n}PrMgCl$), to obtain about 18 g (yield 47%) 3-butyl-1-methylcyclopenta-1,3-diene represented by Formula 4-2 as a colorless and transparent liquid compound, which was used to synthesize a composition for film deposition.

### <Preparation Example 3> Preparation of a methylpropylcyclopentadiene mixture composition

[Formula 4-1]

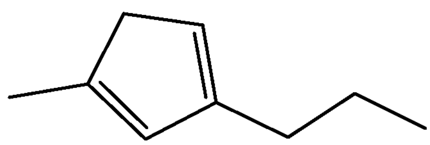

[Formula 4-3]

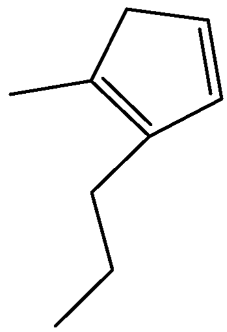

[Formula 4-4]

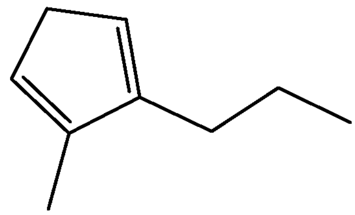

A flame-dried, 1,000-ml Schlenk flask was charged with about 50.0 g (0.624 mole) of methylcyclopentadiene and about 400 ml of tetrahydrofuran (THF, $C_4H_8O$), which was cooled to -20°C. About 173.79 g (0.624 mole) of n-butyllithium ($^{n}$BuLi) was slowly dropwise added to the flask while maintaining -20°C, and then the reaction solution was stirred at room temperature for about 4 hours.

Upon completion of the reaction, 67.07 g (0.562 mole) of 1-bromopropane ($C_3H_7Br$) was slowly dropwise added while maintaining -20°C, and then the reaction solution was slowly raised to room temperature and stirred for 12 hours.

Upon completion of the reaction, salts formed during the reaction were removed through a filtration process, the organic layer was extracted with diethyl ether ($(C_2H_5)_2O$), moisture was removed using magnesium sulfate ($MgSO_4$), and the solvents and volatile by-products were removed by distillation under a reduced pressure to obtain 28.12 g (37.2%) of a colorless transparent liquid mixture composition represented by Formula 4-1, Formula 4-3, and Formula 4-4. It was used to synthesize the composition for film deposition of Comparative Example 5.

**<Preparation Example 4> Preparation of a diethylcyclopentadiene mixture composition**

[Formula 4-5]

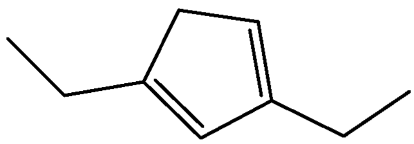

[Formula 4-6]

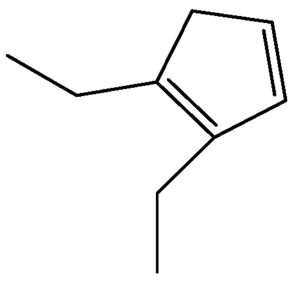

[Formula 4-7]

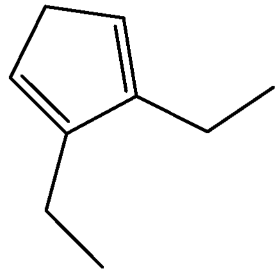

A flame-dried, l-liter Schlenk flask was charged with about 41.88 g (about 1.074 moles) of sodium amide ($NaNH_2$) and about 500 ml of tetrahydrofuran (THF, $C_4H8O$), which was then stirred. About 100 g (about 1.074 moles) of ethylcyclopentadiene ($C_7H_{10}$) was slowly added at about -20°C, and the temperature was then gradually raised to room temperature under stirring, followed by stirring thereof for 17 hours. Upon completion of the reaction, about 116.98 g (about 1.074 moles) of 1-bromoethane ($C_2H_5Br$) was slowly added at about -20°C, and the temperature was then gradually raised to room temperature under stirring, followed by stirring thereof for 17 hours. Upon completion of the reaction, salts formed during the reaction were removed through a filtration process, and the solvents and volatile by-products were removed by distillation under a reduced pressure to obtain 62 g (yield 47.7%) of colorless and transparent liquid mixture composition represented by Formula 4-5, Formula 4-6, and Formula 4-7. It was used to synthesize the composition for film deposition of Comparative Example 4.

**Example**

**<Example 1> Preparation of [(Me,$^n$Pr)Cp]Zr($NMe_2$)$_3$ and a composition for film deposition comprising the same**

[Formula 2-1]

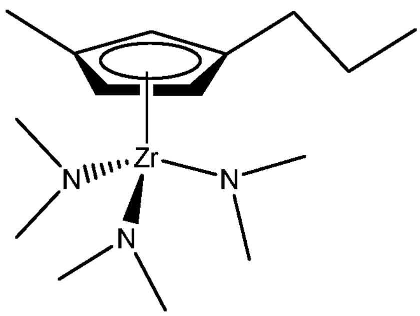

A flame-dried, l-liter Schlenk flask was charged with about 80 g (about 0.300 mole) of tetrakis(dimethylamido) zirconium (VI) and about 500 ml of n-hexane ($C_6H_{14}$) at room temperature. About 39 g (about 0.315 mole) of 1-methyl-3-propylcyclopenta-1,3-diene obtained in Preparation Example 1 was slowly dropwise added to the flask, and then the reaction solution was stirred at room temperature for about 3 hours.

Upon completion of the reaction, the solvent was removed under a reduced pressure, and the resultant was distilled under a reduced pressure to obtain about 61 g (yield 60%) of a pale yellow liquid compound represented by Formula 2-1, which was used to prepare a composition for film deposition.

Boiling point (bp): 100°C (0.3 Torr)
$^1$H-NMR (400 MHz, $C_6D_6$, 25°C):

δ 5.797, 5.763 (m, 3H, $[(CH_3CH_2CH_2)(CH_3)(C_5\underline{H_3})]Zr[N(CH_3)_2]_3$,
δ 3.033 (s, 18H, $[(CH_3CH_2CH_2)(CH_3)(C_5H_3)]Zr[N(C\underline{H_3})_2]_3$,
δ 2.448 (t, 2H, $[(CH_3CH_2C\underline{H_2})(CH_3)(C_5H_3)]Zr[N(CH_3)_2]_3$,
δ 2.094 (s, 3H, $[(CH_3CH_2CH_2)(C\underline{H_3})(C_5H_3)]Zr[N(CH_3)_2]_3$,
δ 1.577 (m, 2H, $[(CH3C\underline{H_2}CH_2)(CH_3)(C_5H_3)]Zr[N(CH_3)_2]_3$,

δ 0.923 (t, 3H, $[(C\underline{H_3}CH_2CH_2)(CH_3)(C_5H_3)]Zr[N(CH_3)_2]_3$.

**<Example 2> Preparation of [(Me,$^n$Bu)Cp]Zr(NMe$_2$)$_3$ and a composition for film deposition comprising the same**

[Formula 2-2]

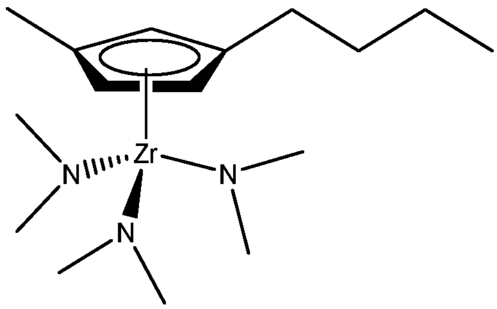

The same method as in Example 1 was used, except that 3-buthyl-1-methylcyclopenta-1,3-diene obtained in Preparation Example 2 was used instead of 1-methyl-3-propylcyclopenta-1,3-diene, to obtain about 65 g (yield 60%) of a pale yellow liquid compound represented by Formula 2-2, which was used to synthesize a composition for film deposition.

Boiling point (bp): 110°C (0.3 Torr)
$^1$H-NMR (400 MHz, $C_6D_6$, 25°C):

δ 5.818, 5.777 (m, 3H, $[(CH_3CH_2CH_2CH_2)(CH_3)(C_5\underline{H_3})]Zr[N(CH_3)_2]_3$,
δ 2.973 (s, 18H, $[(CH_3CH_2CH_2CH_2)(CH_3)(C_5H_3)]Zr[N(C\underline{H_3})_2]_3$,
δ 2.493 (t, 2H, $[(CH_3CH_2CH_2C\underline{H_2})(CH_3)(C_5H_3)]Zr[N(CH_3)_2]_3$,
δ 2.102 (s, 3H, $[(CH_3CH_2CH_2CH_2)(C\underline{H_3})(C_5H_3)]Zr[N(CH_3)_2]_3$,
δ 1.547 (m, 2H, $[(CH_3CH_2C\underline{H_2}CH_2)(CH_3)(C_5H_3)]Zr[N(CH_3)_2]_3$,
δ 1.338 (m, 2H, $[(CH_3CH_2C\underline{H_2}CH_2)(CH_3)(C_5H_3)]Zr[N(CH_3)_2]_3$,
δ 0.904 (t, 3H, $[(C\underline{H_3}CH_2CH_2CH_2)(CH_3)(C_5H_3)]Zr[N(CH_3)_2]_3$.

**<Example 3> Preparation of [(Me,$^n$Pr)Cp]Hf(NMe$_2$)$_3$ and a composition for film deposition comprising the same**

[Formula 3-1]

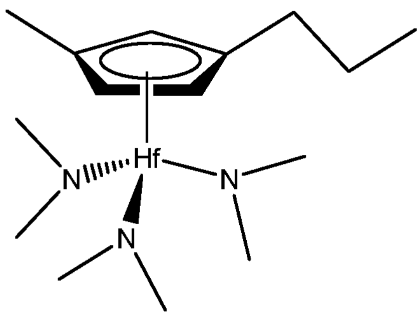

A flame-dried, 1-liter Schlenk flask was charged with about 65 g (about 0.184 mole) of tetrakis(dimethylamido) hafnium (VI) and about 400 ml of n-hexane ($C_6H_{14}$) at room temperature. About 27 g (about 0.220 mole) of 1-methyl-3-propylcyclopenta-1,3-diene obtained in Preparation Example 1 was slowly dropwise added to the flask, and then the reaction solution was stirred at room temperature for about 3 hours.

Upon completion of the reaction, the solvent was removed under a reduced pressure, and the resultant was

distilled under a reduced pressure to obtain about 42 g (yield 53%) of a pale yellow liquid compound represented by Formula 3-1, which was used to prepare a composition for film deposition.

Boiling point (bp): 100°C (0.3 Torr)
$^1$H-NMR (400 MHz, $C_6D_6$, 25°C):

$\delta$ 5.750, 5.724 (m, 3H, $[(CH_3CH_2CH_2)(CH_3)(C_5H_3)]Hf[N(CH_3)_2]_3$,
$\delta$ 2.987 (s, 18H, $[(CH_3CH_2CH_2)(CH_3)(C_5H_3)]Hf[N(CH_3)_2]_3$,
$\delta$ 2.466 (t, 2H, $[(CH_3CH_2CH_2)(CH_3)(C_5H_3))Hf[N(CH_3)_2]_3$,
$\delta$ 2.119 (s, 3H, $[(CH_3CH_2CH_2)(CH_3)(C_5H_3))Hf[N(CH_3)_2]_3$,
$\delta$ 1.541 (m, 2H, $[(CH_3CH_2CH2)(CH3)(C_5H_3))Hf[N(CH_3)_2]_3$,
$\delta$ 0.909 (t, 3H, $[(CH_3CH_2CH_2)(CH_3)(C_5H_3))Hf[N(CH_3)_2]_3$.

**<Example 4> Preparation of $[(Me,^nBu)Cp]Hf(NMe_2)_3$ and a composition for film deposition comprising the same**

[Formula 3-2]

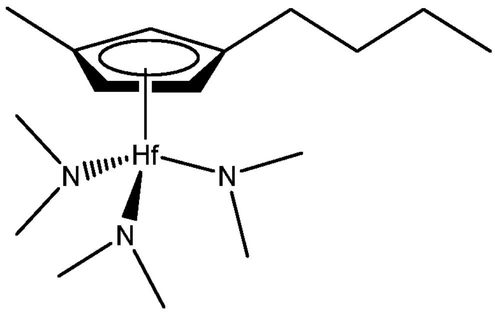

The same method as in Example 3 was used, except that 3-buthyl-1-methylcyclopenta-1,3-diene obtained in Preparation Example 2 was used instead of 1-methyl-3-propylcyclopenta-1,3-diene, to obtain about 65 g (yield 60%) of a pale yellow liquid compound represented by Formula 3-2, which was used to synthesize a composition for film deposition.

Boiling point (bp): 110°C (0.3 Torr)
$^1$H-NMR (400 MHz, $C_6D_6$, 25°C):

$\delta$ 5.767, 5.759 (m, 3H, $[(CH_3CH_2CH_2CH_2)(CH_3)(C_5H_3)]$-$Hf[N(CH_3)_2]_3$,
$\delta$ 3.011 (s, 18H, $[(CH_3CH_2CH_2CH_2)(CH_3)(C_5H_3)]Hf[N(CH_3)_2]_3$,
$\delta$ 2.524 (t, 2H, $[(CH_3CH_2CH_2CH_2)(CH_3)(C_5H_3)]Hf[N(CH_3)_2]_3$,
$\delta$ 2.132 (s, 3H, $[(CH_3CH_2CH_2CH_2)(CH_3)(C_5H_3)]Hf[N(CH_3)_2]_3$,
$\delta$ 1.537 (m, 2H, $[(CH_3CH_2CH_2CH_2)(CH_3)(C_5H_3)]Hf[N(CH_3)_2]_3$,
$\delta$ 1.330 (m, 2H, $[(CH_3CH_2CH_2CH_2)(CH_3)(C_5H_3)]Hf[N(CH_3)_2]_3$,
$\delta$ 0.901 (t, 3H, $[(CH_3CH_2CH_2CH_2)(CH_3)(C_5H_3)]Hf[N(CH_3)_2]_3$.

**<Comparative Example 1>**

A product of cyclopentadienyl-tris(dimethylamido) zirconium ($CpZr(NMe_2)_3$ or CpZr) by UP Chemical was used.

**<Comparative Example 2>**

A product of cyclopentadienyl-tris(dimethylamido) hafnium ($CpHf(NMe_2)_3$ or CpHf) by UP Chemical was used.

**<Comparative Example 3>**

A product of $^n$propylcyclopentadienyl-tris(dimethylamido) zirconium, $(^nPrCp)Zr(NMe_2)_3$ or "PrCpZr) by UP Chemical was used.

**<Comparative Example 4> Preparation of $[(Et)_2Cp]Zr(NMe_2)_3$ mixture composition**

[Formula 2-4]

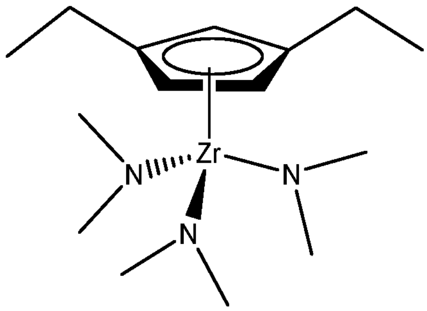

[Formula 2-5]

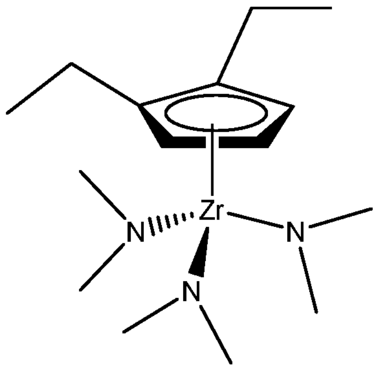

The same method as in Example 1 was used, except that the diethylcyclopentadiene mixture composition represented by Formulae 4-5 to 4-7 obtained in Preparation Example 4 was used instead of 1-methyl-3-propylcyclopenta-1,3-diene, to obtain about 49 g (yield 71.1%) of a pale yellow liquid mixture composition represented by Formulae 2-4 and 2-5. It was used to synthesize a composition for film deposition.

**<Comparative Example 5> Preparation of $[(^{n}Pr,Me)Cp]Hf(NMe_2)_3$ mixture composition**

[Formula 3-1]

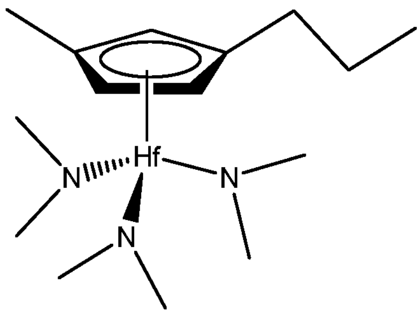

[Formula 3-4]

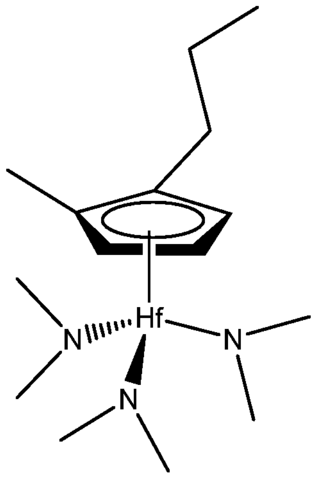

A flame-dried, 1-liter Schlenk flask was charged withabout 54 g (about 0.152 mole) of tetrakis(dimethylamido) hafnium (VI) and about 500 ml of n-hexane ($C_6H_{14}$) at room temperature. About 27 g (about 0.220 mole) of the methylpropylcyclopentadiene mixture represented by Formulae 4-1, 4-3, and 4-4 obtained in Preparation Example 3 was slowly dropwise added to the flask, and then the reaction solution was stirred at room temperature for about 3 hours.

Upon completion of the reaction, the solvent was removed under a reduced pressure, and the resultant was distilled under a reduced pressure to obtain about 42.2 g (yield 64%) of a pale yellow liquid mixture composition represented by Formulae 3-1 and 3-4 having a composition of about 1:1.87. The ratio of the two isomers having the same molecular weight was determined as the relative ratio of integral values of the $^1$-NMR peaks at 2.119 ppm (Formula 3-1) and 2.043 ppm (Formula 3-4) where the hydrogen of methyl ($CH_3$) bound to the ligand cyclopentadiene ring in a $^1$H-NMR (400 MHz, C6D6, 25°C) spectrum.

Boiling point (bp): 100°C (0.3 Torr)
$^1$H-NMR (400 MHz, $C_6D_6$, 25°C):

Compound represented by Formula 3-1: $[(1\text{-}^n Pr,3\text{-}Me)Cp]Hf(NMe_2)_3$
$\delta$ 5.750, 5.724 (m, 3H, $[(CH_3CH_2CH_2)(CH_3)(C_5\underline{H_3})]Hf[N(CH_3)_2]_3$,
$\delta$ 2.987 (s, 18H, $[(CH_3CH_2CH_2)(CH_3)(C_5H_3)]Hf[N(C\underline{H_3})_2]_3$,
$\delta$ 2.466 (t, 2H, $[(CH_3CH_2C\underline{H_2})(CH_3)(CsH_3))Hf[N(CH_3)_2]_3$,
$\delta$ 2.119 (s, 3H, $[(CH_3CH_2CH_2)(C\underline{H_3})(C_5H_3))Hf[N(CH_3)_2]_3$,
$\delta$ 1.541 (m, 2H, $[(CH_3CH_2C\underline{H_2})(CH_3)(C_5H_3))Hf[N(CH_3)_2]_3$,
$\delta$ 0.909 (t, 3H, $[(C\underline{H_3}CH_2CH_2)(CH_3)(C_5H_3))Hf[N(CH_3)_2]_3$.
Compound represented by Formula 3-4: $[(1\text{-}^n Pr,2\text{-}Me)Cp]Hf(NMe_2)_3$
$\delta$ 5.913, 5.842 (m, 3H, $[(CH_3CH_2CH_2)(CH_3)(C_5\underline{H_3})]Hf[N(CH_3)_2]_3$,
$\delta$ 2.995 (s, 18H, $[(CH_3CH_2CH_2)(CH_3)(C_5H_3)]Hf[N(C\underline{H_3})_2]_3$,
$\delta$ 2.408 (t, 2H, $[(CH_3CH_2C\underline{H_2})(CH_3)(C_5H_3))Hf[N(CH_3)_2]_3$,
$\delta$ 2.043 (s, 3H, $[(CH_3CH_2CH_2)(C\underline{H_3})(C_5H_3))Hf[N(CH_3)_2]_3$,
$\delta$ 1.498 (m, 2H, $[(CH3C\underline{H_2}CH_2)(CH_3)(C_5H_3))Hf[N(CH_3)_2]_3$,
$\delta$ 0.886 (t, 3H, $[(C\underline{H_3}CH_2CH_2)(CH_3)(C_5H_3))Hf[N(CH_3)_2]_3$.

**Test Example**

<Test Example 1> Structural analysis of the precursor compounds

$^1$H-NMR (400 MHz, $C_6D_6$, 25°C) analysis was carried out to analyze the structure of the Group 4 metal element-containing precursor compounds prepared in the Examples and Comparative Examples. The results are shown in the Examples and Comparative Examples above.

In addition, as can be seen from Fig. 1, the hafnium (Hf)-containing precursor compound of Comparative Example 5 had a composition of two structures (mixed structure) attributed to structural isomers. In the $^1$H-NMR spectrum, $^1$H-NMR peaks are observed at 2.119 ppm (Formula 3-1) and 2.043 ppm (Formula 3-4) where the hydrogen of methyl ($CH_3$) bound to the ligand cyclopentadiene ring appears (the ratio of Formula 3-1 to Formula 3-4 (relative ratio of integral

values of peaks) is about 1:1.87). On the other hand, the hafnium (Hf)-containing precursor compound prepared in Example 3 of the present invention was confirmed to have a single composition in $^1$H-NMR analysis.

It is confirmed from the results of structural analysis that the hafnium (Hf)-containing precursor compounds of Example 3 is a precursor of high purity sufficient to be applied to an ALD process. Accordingly, the group 4 metal element-containing precursor compounds prepared by the method of the Examples can be used for the purpose of forming various films.

**<Test Example 2> Zirconium (Zr)-containing oxide film formed by atomic layer deposition (ALD) and evaluation of GPC with respect to temperature**

The composition for film deposition comprising a zirconium (Zr)-containing precursor compound prepared by the method of Example 1 and ozone ($O_3$) as a reaction gas were used to form a zirconium (Zr)-containing oxide film on a silicon substrate heated to a temperature (process temperature) of about 250°C to 400°C by ALD.

Specifically, first, a silicon substrate was provided to an ALD reaction chamber.

Thereafter, the composition for film deposition prepared by the method of Example 1 was charged to a stainless-steel canister and heated to about 120°C. An argon (Ar) transport gas flowed at a flow rate of about 200 to 500 sccm to the stainless-steel canister to supply the composition for film deposition in a gaseous state to the reaction chamber. The temperature of the gas transfer tube connected from the stainless-steel canister to the reaction chamber was about 120°C to 150°C. The closer to the reaction chamber, the higher the temperature. Oxygen gas ($O_2$) was supplied to an ozone ($O_3$) generator at a flow rate of 500 to 1,000 sccm to produce ozone ($O_3$) at a concentration of about 180 to 220 g/m$^3$, which was supplied to the reaction chamber and used as a reaction gas. In order to remove the zirconium (Zr)-containing precursor, ozone ($O_3$), and reaction by-products remaining in the reaction chamber, argon (Ar) gas was supplied to the reaction chamber at a flow rate of about 500 to 2,000 sccm. The process pressure of the reaction chamber was maintained at 0.9 to 1.2 Torr.

The ALD gas supply cycle was repeated 100 times to form a zirconium (Zr)-containing oxide film, in which each ALD gas supply cycle consists of the steps of supplying the composition for film deposition in a gaseous state for about 5 to 30 seconds; supplying argon (Ar) gas for about 5 to 30 seconds to remove the composition for film deposition (gas) remaining in the reactor; supplying ozone ($O_3$) as a reaction gas for about 5 to 30 seconds; and supplying argon (Ar) gas for about 5 to 30 seconds to remove ozone ($O_3$) remaining in the reactor.

Zirconium (Zr) oxide films were also formed using the compositions for film deposition comprising a zirconium (Zr)-containing precursor compound of Comparative Example 1, Comparative Example 3, and Comparative Example 4 under the same conditions as the above film formation method of Test Example 2, except that the stainless-steel canister was heated to 100°C, 110°C, and 120°C, respectively, for vaporizing each composition comprising a zirconium (Zr)-containing precursor compound of Comparative Example 1, Comparative Example 3, and Comparative Example 4.

The thickness of each zirconium (Zr) oxide film formed using the compositions for film deposition prepared by the methods of Example 1, Comparative Example 1, Comparative Example 3, and Comparative Example 4 was measured using an ellipsometer (M-2000, J.A. Woollam).

Thereafter, the measured thickness was divided by the number of gas supply cycles (100 times) to calculate the GPC. Specifically, the GPC with respect to a temperature (process temperature) in the range of 250°C to 400°C was calculated. The results are shown in Fig. 2 and Table 1.

In addition, the change in GPC(ΔGPC, %) with respect to process temperature according to the following Equation A was calculated. The results are shown in Table 1.

[Equation A]

$$\text{Change in GPC} \quad (\Delta\text{GPC}, \%) = \frac{\text{GPC}_{temp} - \text{GPC}_{250}}{\text{GPC}_{250}} \times 100$$

In Equation A, $GPC_{250}$ is the GPC at 250°C, and $GPC_{temp}$ is the GPC at a process temperature.

**<Test Example 3> Hafnium (Hf)-containing oxide film formed by atomic layer deposition (ALD) and evaluation of GPC with respect to temperature**

The composition for film deposition comprising a hafnium (Hf)-containing precursor compound prepared by the method of Example 3 and ozone ($O_3$) as a reaction gas were used to form a hafnium (Hf)-containing oxide film on a silicon substrate heated to a process temperature of about 250°C to 400°C by ALD.

Specifically, first, a silicon substrate was provided to an ALD reaction chamber.

Thereafter, the composition for film deposition prepared by the method of Example 3 was charged to a stainless-steel canister and heated to about 120°C. An argon (Ar) transport gas flowed at a flow rate of about 200 to 500 sccm to the stainless-steel canister to supply the composition for film deposition in a gaseous state to the reaction chamber. The temperature of the gas transfer tube connected from the stainless-steel canister to the reaction chamber was about 120°C to 150°C. The closer to the reaction chamber, the higher the temperature. Oxygen gas ($O_2$) was supplied to an ozone ($O_3$) generator at a flow rate of 500 to 1,000 sccm to produce ozone ($O_3$) at a concentration of about 180 to 220 g/$m^3$, which was supplied to the reaction chamber and used as a reaction gas. In order to remove the hafnium (Hf)-containing precursor, ozone ($O_3$), and reaction by-products remaining in the reaction chamber, argon (Ar) gas was supplied to the reaction chamber at a flow rate of about 500 to 2,000 sccm. The process pressure of the reaction chamber was maintained at 0.9 to 1.2 Torr.

The ALD gas supply cycle was repeated 100 times to form a hafnium (Hf)-containing oxide film, in which each ALD gas supply cycle consists of the steps of supplying the composition for film deposition in a gaseous state for about 5 to 30 seconds; supplying argon (Ar) gas for about 5 to 30 seconds to remove the composition for film deposition (gas) remaining in the reactor; supplying ozone ($O_3$) as a reaction gas for about 5 to 30 seconds; and supplying argon (Ar) gas for about 5 to 30 seconds to remove ozone ($O_3$) remaining in the reactor.

Hafnium (Hf) oxide films were also formed using the composition for film deposition comprising a hafnium (Hf)-containing precursor compound of Comparative Example 2 under the same conditions as the above film formation method of Test Example 3, except that the stainless-steel canister was heated to 100°C for vaporizing the composition for film deposition comprising a hafnium (Hf)-containing precursor compound of Comparative Example 2.

The thickness of each hafnium (Hf) oxide film formed using the compositions for film deposition prepared by the methods of Example 3 and Comparative Example 2 was measured using an ellipsometer (M-2000, J.A. Woollam).

Thereafter, the measured thickness was divided by the number of gas supply cycles (100 times) to calculate the GPC. Specifically, the GPC with respect to a temperature (process temperature) in the range of 250°C to 450°C was calculated. The results are shown in Fig. 3 and Table 2.

In addition, the change in GPC (ΔGPC, %) with respect to temperature according to the above Equation A was calculated. The results are shown in Table 2.

[Table 1]

| | Characteristics | Process temp. (°C) | | | | | | | | | | | | |
|---|---|---|---|---|---|---|---|---|---|---|---|---|---|---|
| | | 250 | 275 | 300 | 310 | 320 | 330 | 340 | 350 | 360 | 370 | 380 | 390 | 400 |
| Ex. 1 | GPC (Å/cycle) | 0.68 | 0.70 | 0.69 | 0.70 | 0.69 | 0.70 | 0.72 | 0.71 | 0.74 | 0.75 | 0.76 | 0.79 | 0.88 |
| | ΔGPC (%) | 0% | 3% | 1% | 3% | 1% | 3% | 6% | 4% | 9% | 10% | 12% | 16% | 29% |
| C. Ex. 1 | GPC (Å/cycle) | 0.79 | 0.87 | 1.01 | 1.14 | 1.28 | 1.58 | 1.95 | | | | | | |
| | ΔGPC (%) | 0% | 10% | 28% | 44% | 62% | 100% | 147% | | | | | | |
| C. Ex. 3 | GPC (Å/cycle) | 0.76 | 0.76 | 0.78 | 0.80 | 0.80 | 0.80 | 0.83 | | 0.87 | | 0.93 | | 1.01 |
| | ΔGPC (%) | 0% | 0% | 3% | 5% | 5% | 5% | 9% | | 14% | | 22% | | 33% |
| C. Ex. 4 | GPC (Å/cycle) | 0.71 | | 0.73 | | 0.80 | | 0.97 | 1.11 | 1.52 | | | | 4.72 |
| | ΔGPC (%) | 0% | | 3% | | 13% | | 37% | 56% | 114% | | | | 565% |

As can be seen from Fig. 2 and Table 1, as the composition for film deposition comprising a zirconium (Zr)-containing precursor compound of the present invention was used, the self-limiting film growth of ALD could be achieved in a wide temperature range, especially at high temperatures. In addition, when the composition for film deposition of Example 1 was used, the GPC does not vary.

Specifically, when the compositions for film deposition of Comparative Example 1 and Comparative Example 4 were each used, the precursor compound had low thermal stability. Thus, as the temperature was elevated, the GPC rapidly changed, resulting in a change in GPC (ΔGPC) of greater than 100% at 330°C or 360°C, respectively.

This may mean that the film was grown through a gas-phase reaction, other than a surface reaction, due to the thermal decomposition of the precursor compound used in Comparative Example 1 and Comparative Example 4. That is, when a film is grown by a gas-phase reaction, the film is rapidly grown on the upper part of grooves whereas the film is slowly grown on the lower part (bottom) of the narrow and deep groove. In such a case, the merits of ALD cannot be achieved that it can form a film of uniform thickness through a surface reaction even on a surface with deep grooves.

On the other hand, when the composition for film deposition of Example 1 of the present invention was used, the zirconium (Zr)-containing precursor compound contained in the composition for film deposition had excellent thermal stability without thermal decomposition. Thus, even when high temperature was employed for ALD, the GPC does not vary and the change in GPC (ΔGPC) was maintained to be 10% or less up to about 370°C.

In addition, when the composition for film deposition of Comparative Example 3 was used, the change in GPC (ΔGPC) at 380°C was about 22%, showing a significant difference from Example 1 in which the change in GPC (ΔGPC) was about 12% at the same temperature.

[Table 2]

| | Characteristics | | | | | | | | | | | | | | | | | | |
|---|---|---|---|---|---|---|---|---|---|---|---|---|---|---|---|---|---|---|---|
| | | 250 | 275 | 300 | 310 | 320 | 330 | 340 | 350 | 360 | 370 | 380 | 390 | 400 | 410 | 420 | 430 | 440 | 450 |
| Ex.3 | GPC (Å/cycle) | 0.71 | 0.7 | 0.68 | 0.7 | 0.71 | 0.71 | 0.71 | 0.71 | 0.71 | 0.7 | 0.70 | 0.70 | 0.70 | 0.70 | 0.73 | 0.73 | 0.77 | 0.83 |
| | ΔGPC (%) | 0% | -1% | -4% | -1% | 0% | 0% | 0% | 0% | 0% | -1% | -1% | -1% | -1% | -1% | 3% | 3% | 8% | 17% |
| C. Ex. 2 | GPC (Å/cycle) | 0.79 | 0.81 | 0.83 | 0.84 | 0.87 | 0.93 | 0.96 | 1.00 | 1.07 | 1.13 | 1.28 | 1.44 | 1.76 | | | | | |
| | ΔGPC (%) | 0% | 3% | 5% | 6% | 10% | 18% | 22% | 27% | 35% | 43% | 62% | 82% | 123% | | | | | |

As can be seen from Fig. 3 and Table 2, as the composition for film deposition comprising a hafnium (Hf)-containing precursor compound of the present invention was used, the self-limiting film growth of ALD could be achieved in a wide temperature range, especially at high temperatures. In addition, when the composition for film deposition of Example 3 was used, the GPC does not vary.

Specifically, in Comparative Example 2, the precursor compound had low thermal stability. Thus, as the temperature was elevated, the GPC rapidly changed, resulting in a change in GPC (ΔGPC) of greater than 100% at 400°C.

This may mean that the film was grown through a gas-phase reaction, other than a surface reaction, due to the thermal decomposition of the precursor compound used in Comparative Example 2. That is, when a film is grown by a gas-phase reaction, the film is rapidly grown on the upper part of grooves whereas the film is slowly grown on the lower part (bottom) of the narrow and deep groove. In such a case the merits of ALD cannot be achieved that it can form a film of uniform thickness through a surface reaction even on a surface with deep grooves.

On the other hand, in Example 3 of the present invention, the hafnium (Hf)-containing precursor compound contained in the composition for film deposition had excellent thermal stability without thermal decomposition. Thus, even when high temperature was employed for ALD, the GPC does not vary, and the change in GPC (ΔGPC) was maintained to be 8% or less up to about 440°C.

**<Test Example 4> Evaluation of step coverage of a zirconium (Zr)-containing oxide film**

The step coverages of zirconium (Zr)-containing oxide films formed using the compositions for film deposition of Example 1, Comparative Example 1, Comparative Example 3, and Comparative Example 4 were each evaluated.

Specifically, the compositions for film deposition of Example 1, Comparative Example 1, Comparative Example 3, and Comparative Example 4 were each used to form a zirconium (Zr)-containing oxide film having a thickness of about 12 to 15 nm on a substrate, in which grooves having an aspect ratio of 20:1 in a silicon oxide ($SiO_2$) film, by ALD at a process temperature of about 300°C, 340°C, and 360°C.

The thickness and step coverage (%) of the zirconium (Zr)-containing oxide film were measured in the transmission electron microscope (TEM) images of the top, middle, and bottom of the grooves shown in Figs. 4 and 5.

[Table 3]

| | | C. Ex. 1 CpZr | C. Ex. 3 [($^n$Pr)Cp]Zr($NMe_2$)$_3$ | | C. Ex. 4 [(Et)$_2$Cp]Zr($NMe_2$)$_3$ | |
|---|---|---|---|---|---|---|
| | | 300°C | 300°C | 360°C | 300°C | 340°C |
| Thickness of $ZrO_2$ film (nm) | Top | 14.83 | 15.60 | 15.22 | 15.30 | 14.38 |
| | Middle | 12.04 | 15.14 | 14.08 | 14.58 | 11.31 |
| | Bottom | 11.44 | 14.52 | 12.73 | 13.92 | 10.50 |
| Step coverage (bottom thickness/top thickness × 100%) | | 77.1% | 93.1% | 83.6% | 91.0% | 73.0% |

[Table 4]

| | | Ex. 1 [(Me,$^n$Pr)Cp]Zr($NMe_2$)$_3$ | | |
|---|---|---|---|---|
| | | 300°C | 340°C | 360°C |
| Thickness of $ZrO_2$ film (nm) | Top | 13.96 | 14.57 | 12.52 |
| | Middle | 13.87 | 14.38 | 12.53 |
| | Bottom | 13.47 | 14.03 | 12.43 |
| Step coverage (bottom thickness/top thickness × 100%) | | 96.5% | 96.3% | 99.3% |

As can be seen from Figs. 4 and 5 and Tables 3 and 4, when the composition for film deposition of Example 1 of the present invention was used to form a zirconium (Zr)-containing oxide film on a substrate having grooves with an aspect ratio of 20:1 at 300°C, 340°C, and 360°C, the step coverage (%) was excellent as compared with Comparative Example 1, Comparative Example 3, and Comparative Example 4.

In addition, when the composition for film deposition of Example 1 was used, it was confirmed that a zirconium (Zr)-containing oxide film having a very uniform thickness was formed with a step coverage of about 99.3% even at a high temperature of about 360°C.

It is confirmed from the above results that as the composition for film deposition comprising a zirconium (Zr)-containing precursor compound of the present invention is used, the self-limiting film growth of ALD can be achieved over a wide temperature range, especially at high temperatures of about 360°C; thus, it is possible to form a zirconium (Zr)-containing film for various applications at a wide range of process temperatures.

In particular, according to the method for forming a zirconium (Zr)-containing film of the present invention, since the GPC does not vary in a wide temperature range, it is possible to form a zirconium (Zr)-containing film with a uniform thickness even on a surface having grooves with a large aspect ratio. Thus, it can be advantageously used to manufacture various semiconductor devices such as DRAM and 3D NAND flash memory.

**<Test Example 5> Evaluation of step coverage of a hafnium (Hf)-containing oxide film**

The step coverages of the hafnium (Hf)-containing oxide films formed using the compositions for film deposition of Example 3 and Comparative Example 2 were each evaluated.

Specifically, the compositions for film deposition of Example 3 and Comparative Example 2 were each used to form a hafnium (Hf)-containing oxide film having a thickness of about 6 to 7 nm on a substrate, in which a titanium nitride (TiN) film had been formed in grooves with an aspect ratio of 11:1, by ALD at a process temperature of about 350°C and about 400°C.

The thickness and step coverage (%) of the hafnium (Hf)-containing oxide film were measured in the transmission electron microscope (TEM) images of the top, middle, and bottom of the grooves shown in Fig. 6.

[Table 5]

| | | C. Ex. 2 CpHf | Ex. 3 $[(Me,^{n}Pr)Cp]Hf(NMe_2)_3$ | |
|---|---|---|---|---|
| | | 350°C | 350°C | 400°C |
| Thickness of $HfO_2$ film (nm) | Top | 6.65 | 6.65 | 6.14 |
| | Middle | 6.40 | 6.65 | 6.14 |
| | Bottom | 6.37 | 6.42 | 6.06 |
| Step coverage (bottom thickness/top thickness × 100%) | | 95.8% | 96.5% | 98.7% |

As can be seen from Fig. 6 and Table 5, when the composition for film deposition of Example 3 of the present invention was used to form a hafnium (Hf)-containing oxide film on a substrate having a step of an aspect ratio of 11:1 at 350°C and 400°C, the step coverage (%) was excellent.

Specifically, when the composition for film deposition of Example 3 was used, it was confirmed that a hafnium (Hf)-containing oxide film having a very uniform thickness was formed with a step coverage of about 98.7% even at a high temperature of about 400°C.

It is confirmed from the above results that as the composition for film deposition comprising a hafnium (Hf)-containing precursor compound of the present invention is used, the self-limiting film growth of ALD can be achieved over a wide temperature range, especially at high temperatures of about 400°C; thus, it is possible to form a hafnium (Hf)-containing film for various applications at a wide range of process temperatures.

In particular, according to the method for forming a hafnium (Hf)-containing film of the present invention, since the GPC does not vary in a wide temperature range, it is possible to form a hafnium (Hf)-containing film with a uniform thickness even on a surface having grooves with a large aspect ratio. Thus, it can be advantageously used to manufacture various semiconductor devices such as DRAM and 3D NAND flash memory.

## Claims

1. A method for forming a Group 4 metal element-containing film, which comprises subjecting a composition for film deposition comprising a Group 4 metal element-containing precursor compound represented by the following Formula 1 to a reaction with a reaction gas to form a Group 4 metal element-containing film on a substrate:

[Formula 1]

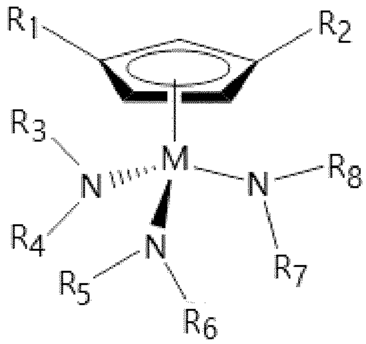

in Formula 1, M is Zr or Hf, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

2. The method for forming a Group 4 metal element-containing film of claim 1, wherein the method for forming a Group 4 metal element-containing film comprises:

providing at least a portion of the substrate to a reaction chamber;
supplying the composition for film deposition in a gaseous state to the reaction chamber; and
feeding the reaction gas into the reaction chamber,
wherein a Group 4 metal element-containing film is formed on the surface of at least a part of the substrate through chemical vapor deposition (CVD) or atomic layer deposition (ALD).

3. The method for forming a Group 4 metal element-containing film of claim 1, wherein the deposition is carried out in a temperature range of 150°C to 500°C.

4. The method for forming a Group 4 metal element-containing film of claim 1, wherein the Group 4 metal element-containing precursor compound is in a structure of a single composition.

5. The method for forming a Group 4 metal element-containing film of claim 1, wherein the Group 4 metal element-containing precursor compound is a compound represented by the following Formula 2:

[Formula 2]

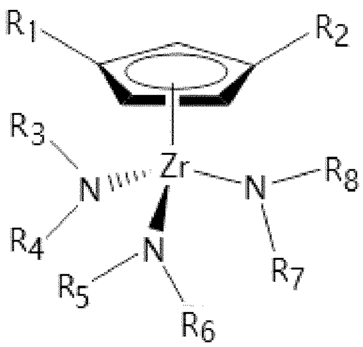

in Formula 2, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

6. The method for forming a Group 4 metal element-containing film of claim 5, wherein the Group 4 metal element-containing precursor compound is a compound represented by one of the following Formulae 2-1 to 2-3:

[Formula 2-1]

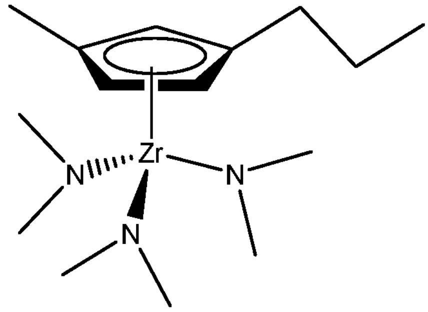

,

[Formula 2-2]

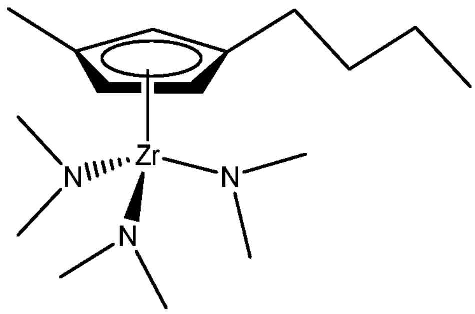

and

[Formula 2-3]

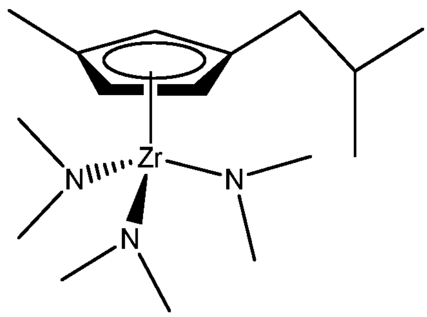

.

**7.** The method for forming a Group 4 metal element-containing film of claim 5, wherein when the compound represented by Formula 2 is used to form a zirconium (Zr)-containing film by atomic layer deposition (ALD) at a process temperature of 250°C to 380°C, the change in GPC (ΔGPC, %) with respect to temperature as represented by the following Equation A is 30% or lower:

[Equation A]

$$\text{Change in GPC } (\Delta\text{GPC}, \%) = \frac{\text{GPC}_{temp} - \text{GPC}_{250}}{\text{GPC}_{250}} \times 100$$

in Equation A, $GPC_{250}$ is the GPC at 250°C, and $GPC_{temp}$ is the GPC at a process temperature.

**8.** The method for forming a Group 4 metal element-containing film of claim 7, wherein when the compound represented by Formula 2 is used to form a zirconium (Zr)-containing film by atomic layer deposition (ALD) at a process temperature of 250°C to 400°C, the change **in** GPC (ΔGPC, %) is 30% or lower.

**9.** The method for forming a Group 4 metal element-containing film of claim 7, wherein when the compound represented by Formula 2 is used to form a zirconium (Zr)-containing film by atomic layer deposition (ALD) at a process temperature of 250°C to 360°C, the change **in** GPC (ΔGPC, %) is 30% or lower.

**10.** The method for forming a Group 4 metal element-containing film of claim **1,** wherein the Group 4 metal element-containing precursor compound is a compound represented by the following Formula 3:

[Formula 3]

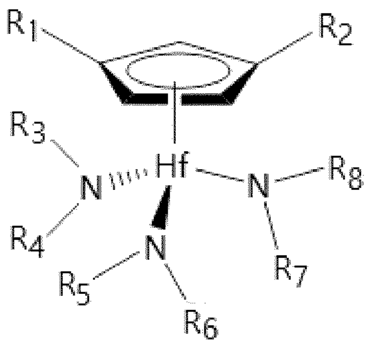

in Formula 3, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

**11.** The method for forming a Group 4 metal element-containing film of claim 10, wherein the Group 4 metal element-containing precursor compound is a compound represented by one of the following Formulae 3-1 to 3-3:

[Formula 3-1]

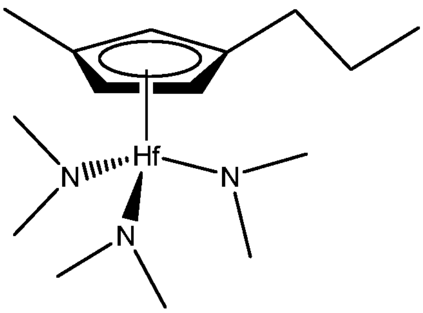

,

[Formula 3-2]

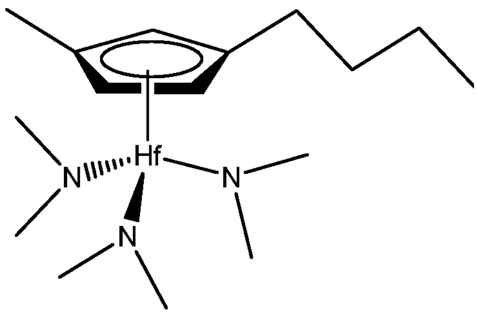

and

[Formula 3-3]

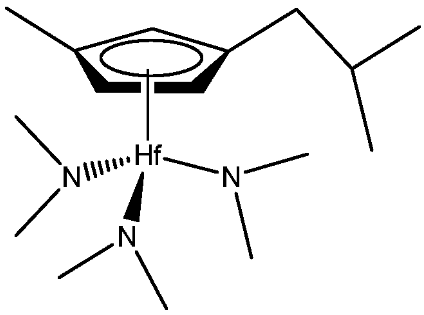

.

**12.** The method for forming a Group 4 metal element-containing film of claim 10, wherein when the compound represented by Formula 3 is used to form a hafnium (Hf)-containing film by atomic layer deposition (ALD) at a process temperature of 250°C to 400°C, the change in GPC (ΔGPC, %) with respect to temperature as represented by the following Equation A is 30% or lower:

[Equation A]

$$\text{Change in GPC } (\Delta\text{GPC}, \%) = \frac{\text{GPC}_{temp} - \text{GPC}_{250}}{\text{GPC}_{250}} \times 100$$

in Equation A, $GPC_{250}$ is the GPC at 250°C, and $GPC_{temp}$ is the GPC at a process temperature.

**13.** The method for forming a Group 4 metal element-containing film of claim 1, wherein the Group 4 metal element-containing film is formed on a substrate having at least one groove having an aspect ratio of 1 or more and a width of 1 μm or less.

**14.** The method for forming a Group 4 metal element-containing film of claim 1, wherein the Group 4 metal element-containing film is formed in a thickness range of 1 nm to 500 nm.

**15.** A composition for film deposition, which comprises a Group 4 metal element-containing precursor compound represented by the following Formula 1:

**[Formula 1]**

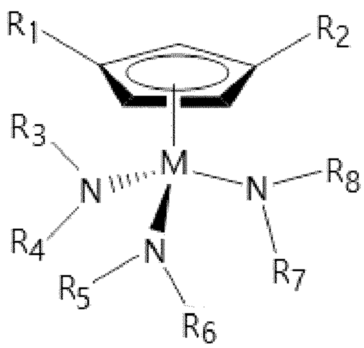

in Formula 1, M is Zr or Hf, $R_1$ is a methyl group, $R_2$ is selected from the group consisting of a linear or branched $C_3$-$C_4$ alkyl group, and $R_3$ to $R_8$ are each independently selected from the group consisting of a linear or branched $C_1$-$C_4$ alkyl group.

**16.** The composition for film deposition of claim 15, wherein the Group 4 metal element-containing precursor compound is a compound represented by one of the following Formulae 2-1 to 2-3:

[Formula 2-1]

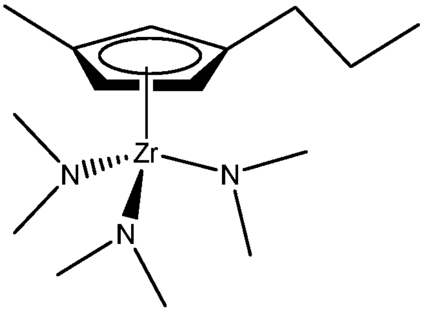

,

[Formula 2-2]

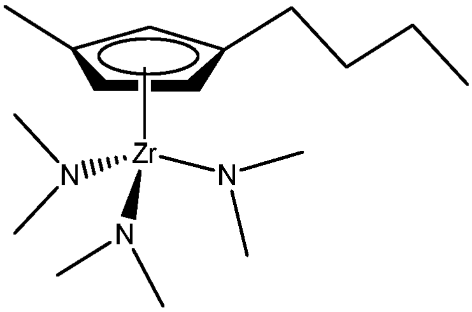

and

[Formula 2-3]

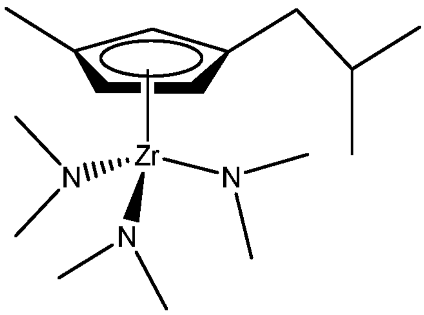

.

**17.** The composition for film deposition of claim 15, wherein the Group 4 metal element-containing precursor compound is a compound represented by one of the following Formulae 3-1 to 3-3:

[Formula 3-1]

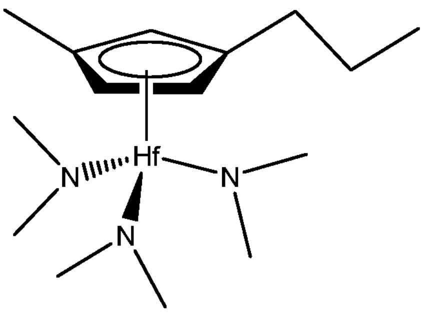

,

[Formula 3-2]

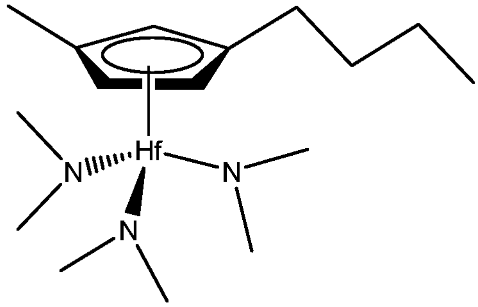

and

[Formula 3-3]

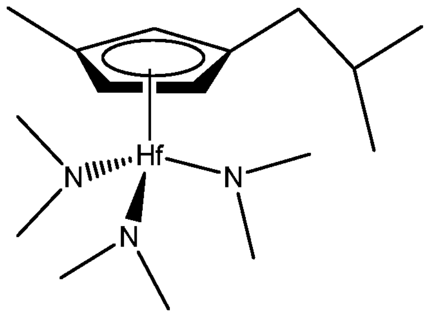

.

**18.** The composition for film deposition of claim 15, wherein the Group 4 metal element-containing precursor compound is in a structure of a single composition.

[Fig. 1]

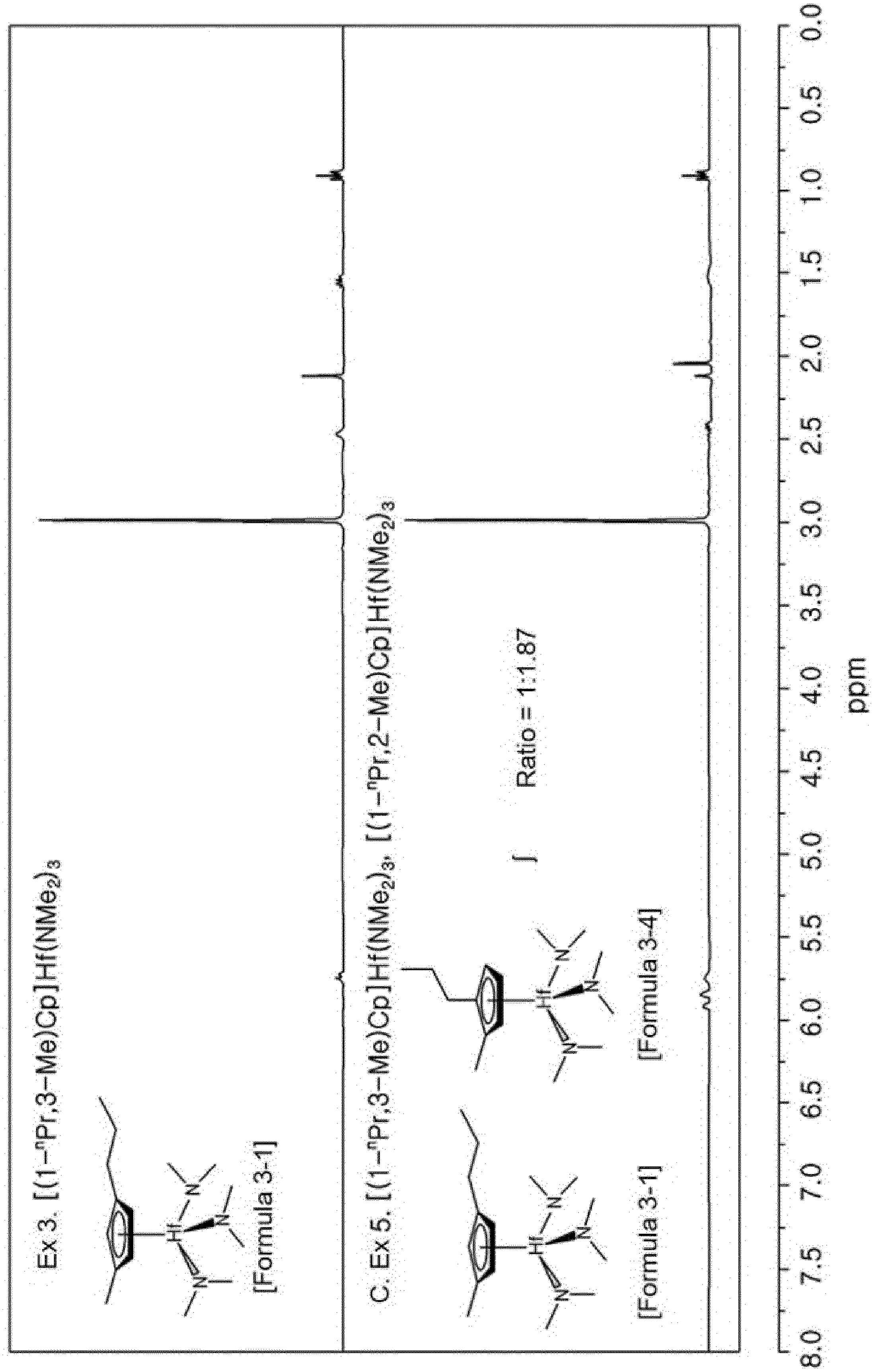
Ex 3. [(1−ⁿPr,3−Me)Cp]Hf(NMe2)3
[Formula 3-1]
C. Ex 5. [(1−ⁿPr,3−Me)Cp]Hf(NMe2)3, [(1−ⁿPr,2−Me)Cp]Hf(NMe2)3
Ratio = 1:1.87
[Formula 3-1]
[Formula 3-4]
0.0
0.5
1.0
1.5
2.0
2.5
3.0
3.5
4.0
4.5
5.0
5.5
6.0
6.5
7.0
7.5
8.0
ppm

[Fig. 2]

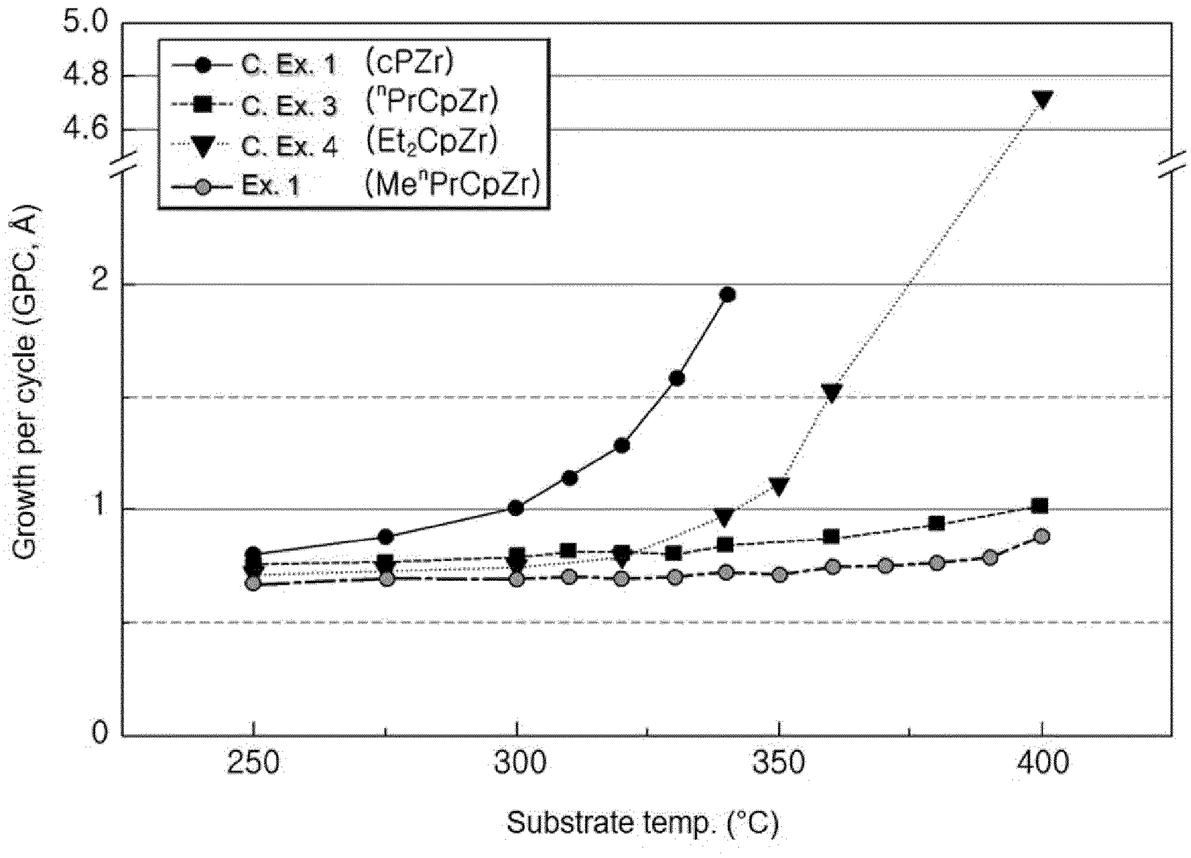
5.0
4.8
4.6
2
1
0
C. Ex. 1 (cPZr)
C. Ex. 3 ($^n$PrCpZr)
C. Ex. 4 ($Et_2$CpZr)
Ex. 1 (Me$^n$PrCpZr)
Growth per cycle (GPC, Å)
250
300
350
400
Substrate temp. (°C)

[Fig. 3]

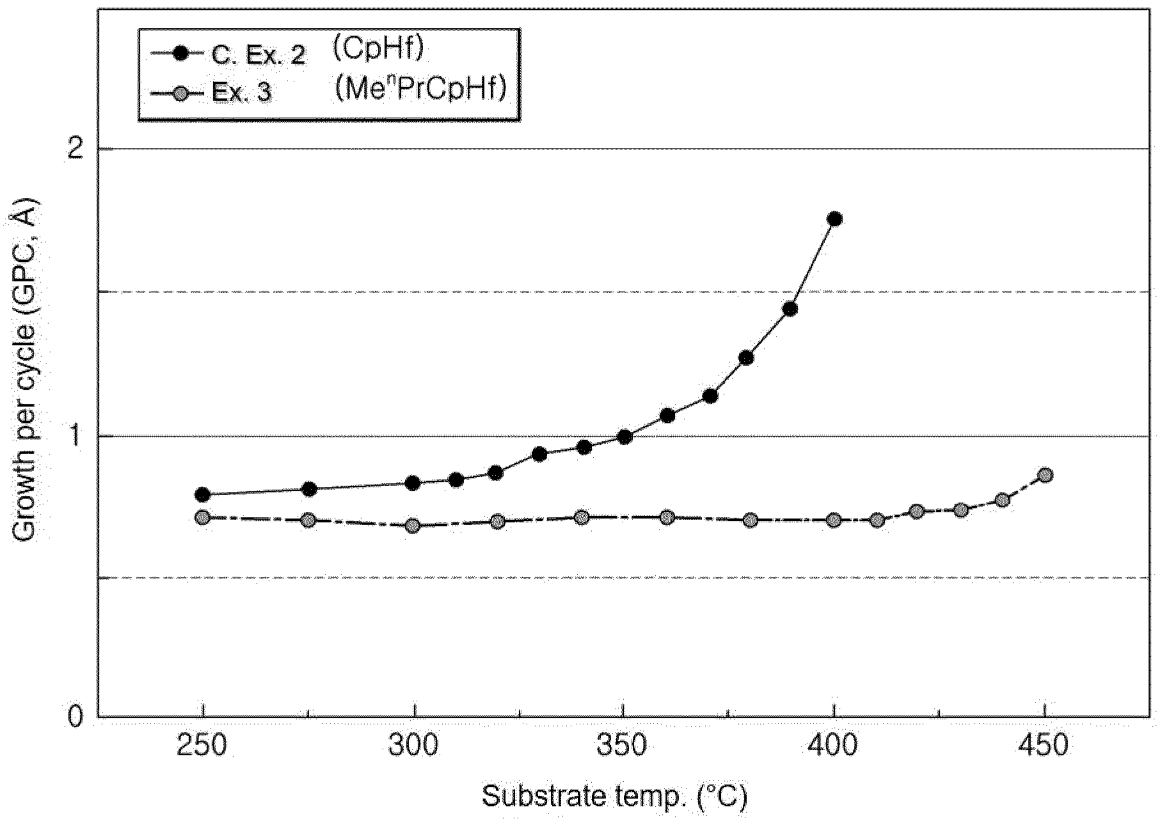
C. Ex. 2 (CpHf)
Ex. 3 (Me$^n$PrCpHf)
Growth per cycle (GPC, Å)
2
1
0
250
300
350
400
450
Substrate temp. (°C)

4/6

[Fig. 4]

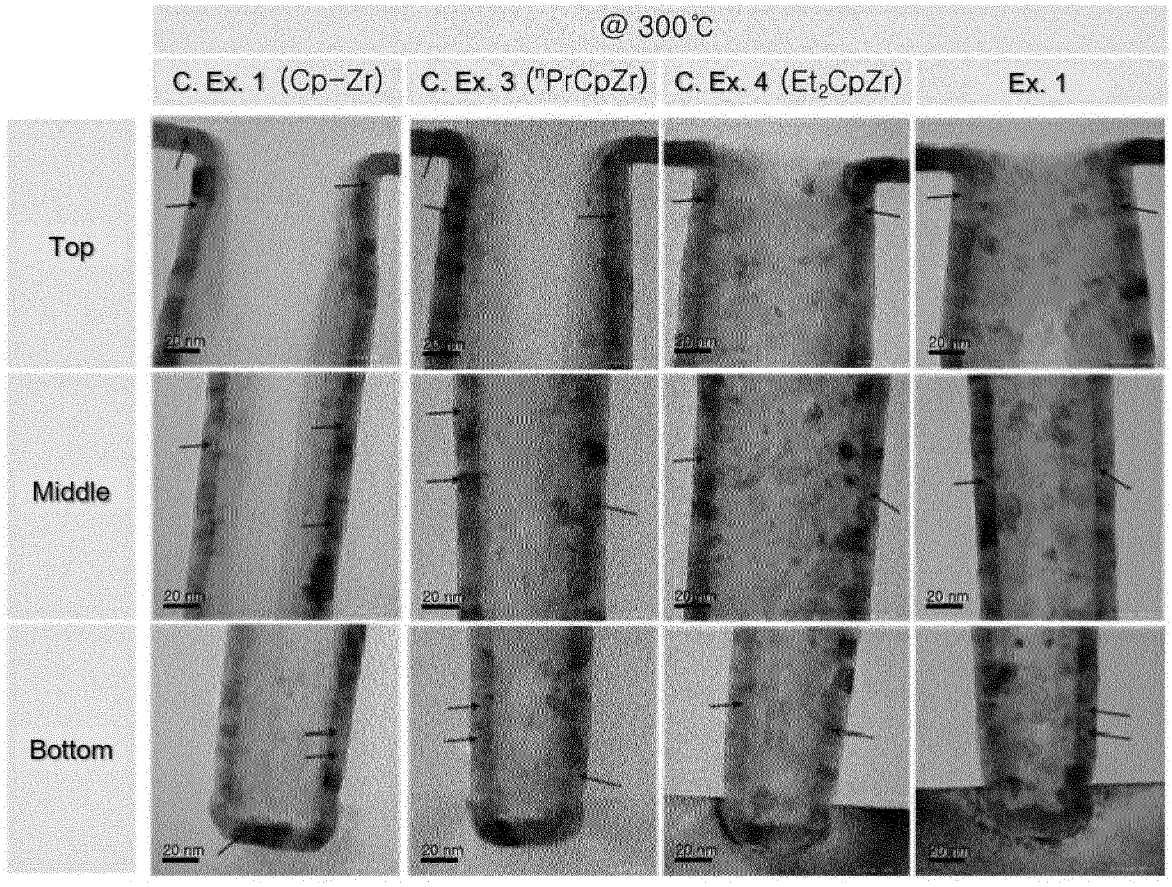
@ 300℃
C. Ex. 1 (Cp-Zr)
C. Ex. 3 (ⁿPrCpZr)
C. Ex. 4 (Et2CpZr)
Ex. 1
Top
Middle
Bottom
20 nm

[Fig. 5]

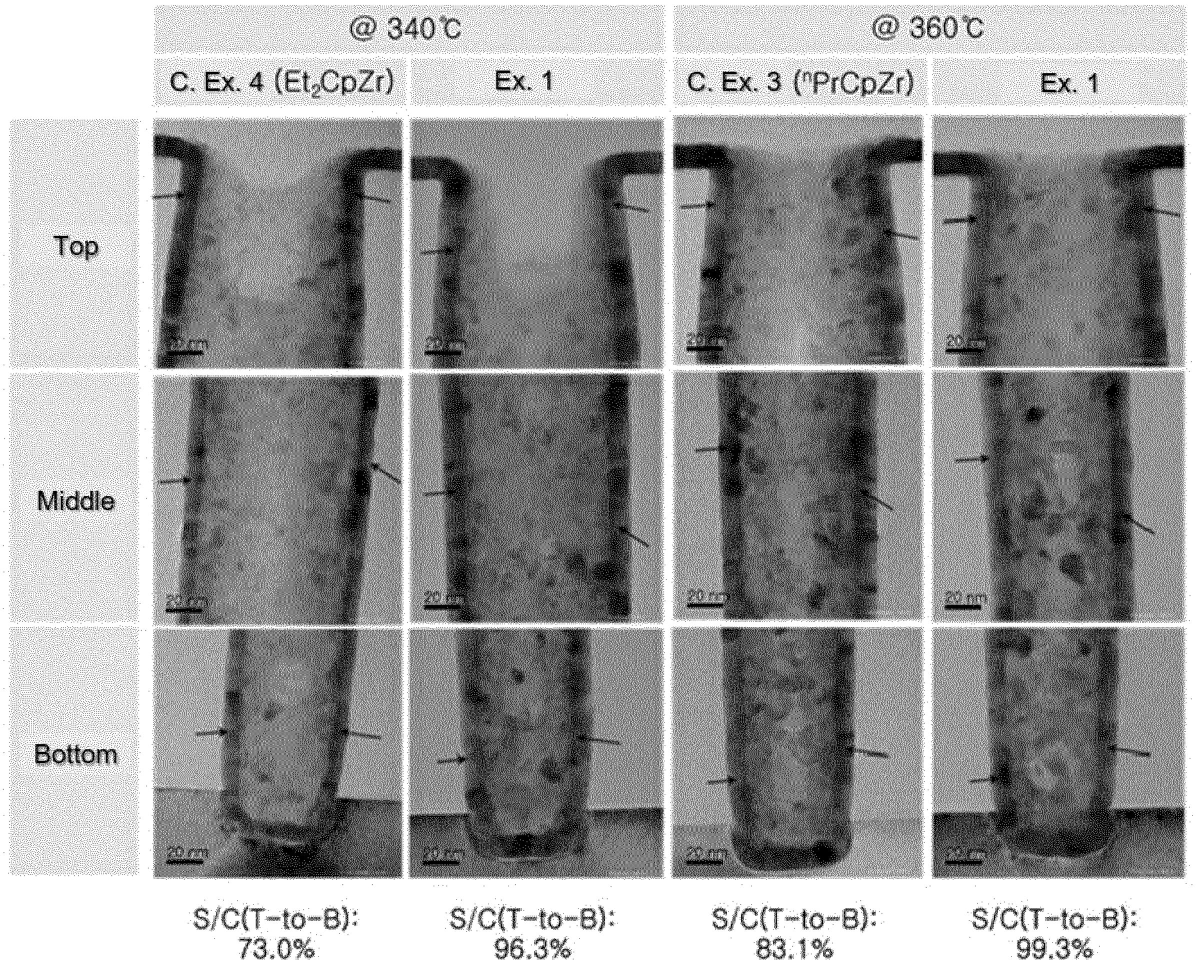
@ 340℃
@ 360℃
C. Ex. 4 (Et2CpZr)
Ex. 1
C. Ex. 3 (nPrCpZr)
Ex. 1
Top
Middle
Bottom
20 nm
S/C(T-to-B): 73.0%
S/C(T-to-B): 96.3%
S/C(T-to-B): 83.1%
S/C(T-to-B): 99.3%

[Fig. 6]

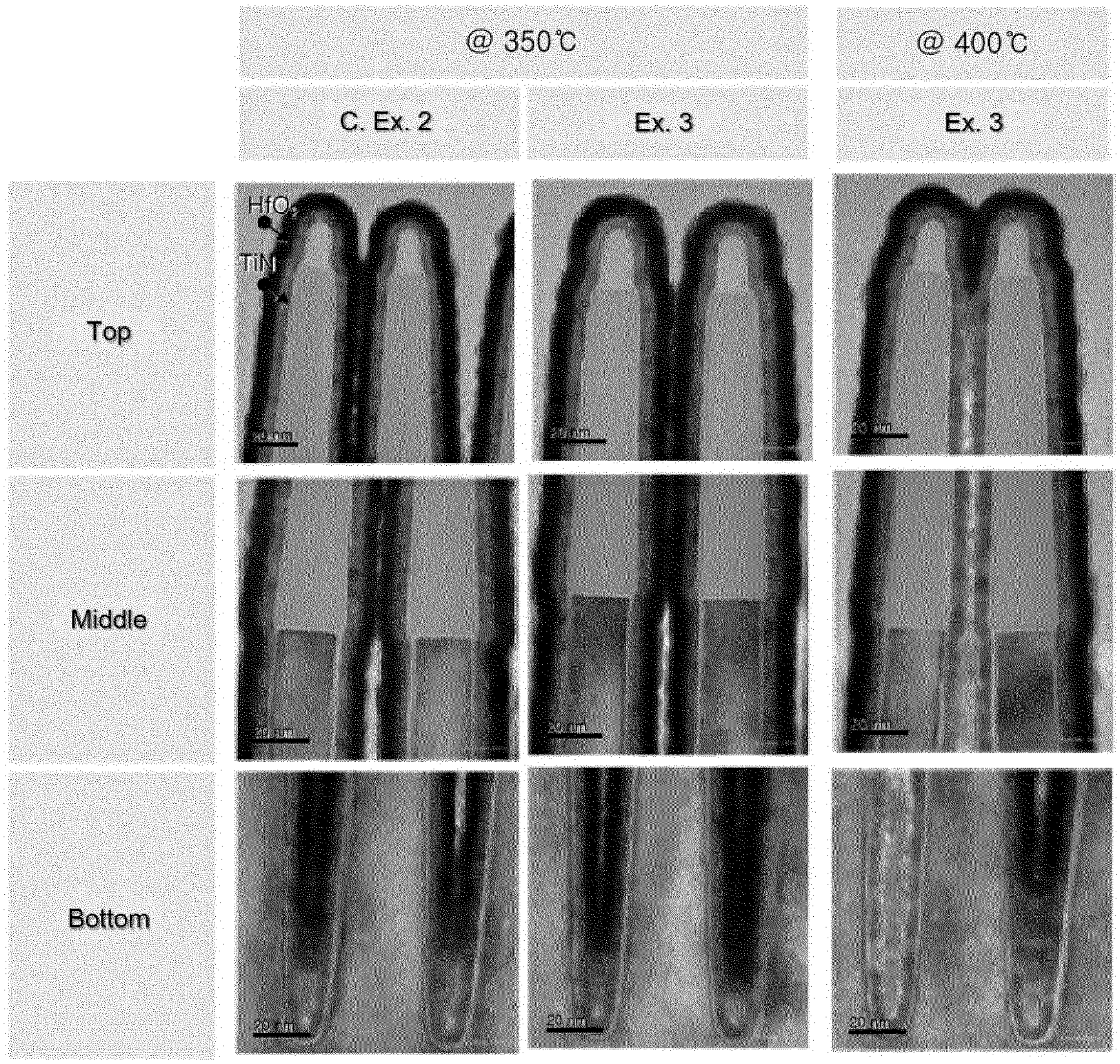

## INTERNATIONAL SEARCH REPORT

International application No.
**PCT/KR2023/006432**

**A. CLASSIFICATION OF SUBJECT MATTER**

**C23C 16/18**(2006.01)i; **C23C 16/40**(2006.01)i; **C23C 16/455**(2006.01)i

According to International Patent Classification (IPC) or to both national classification and IPC

**B. FIELDS SEARCHED**

Minimum documentation searched (classification system followed by classification symbols)

C23C 16/18(2006.01); C07F 17/00(2006.01); C07F 7/00(2006.01); C23C 14/06(2006.01); C23C 14/08(2006.01); C23C 16/30(2006.01); C23C 16/40(2006.01); C23C 16/44(2006.01); C23C 16/455(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus) & keywords: 지르코늄(zirconium), 하프늄(hafnium), 막(film), 전구체(precursor), 화학기상증착(CVD, chemical vapor deposition), 원자층증착(ALD, atom layer deposition), 반도체(semiconductors), 단차 피복성(step coverage)

**C. DOCUMENTS CONSIDERED TO BE RELEVANT**

| Category* | Citation of document, with indication, where appropriate, of the relevant passages | Relevant to claim No. |
|---|---|---|
| X | KR 10-2020-0072407 A (SK TRICHEM) 22 June 2020 (2020-06-22)<br>See claims 1, 6 and 9-13; and paragraphs [0077], [0078], [0083], [0084], [0174] and [0176]-[0178]. | 1-18 |
| A | KR 10-2259874 B1 (WONIK MATERIALS CO., LTD.) 03 June 2021 (2021-06-03)<br>See entire document. | 1-18 |
| A | KR 10-2016-0000392 A (SOULBRAIN SIGMA-ALDRICH, LTD.) 04 January 2016 (2016-01-04)<br>See entire document. | 1-18 |
| A | US 9045509 B2 (DUSSARRAT, C. et al.) 02 June 2015 (2015-06-02)<br>See entire document. | 1-18 |
| A | KR 10-2015-0139628 A (SIGMA-ALDRICH CO. LLC) 11 December 2015 (2015-12-11)<br>See entire document. | 1-18 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 August 2023** | **07 August 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.
**PCT/KR2023/006432**

**C. DOCUMENTS CONSIDERED TO BE RELEVANT**

| Category* | Citation of document, with indication, where appropriate, of the relevant passages | Relevant to claim No. |
|---|---|---|
| PX | WO 2022-146668 A1 (L`AIR LIQUIDE, SOCIETE ANONYME POUR L'ETUDE ET L'EXPLOITATION DES PROCEDES GEORGES CLAUDE et al.) 07 July 2022 (2022-07-07)<br>See claims 1-5, 8, 9, 11-16, 19 and 20. | 1-18 |
| PX | WO 2022-245039 A1 (ICHEMS CO., LTD.) 24 November 2022 (2022-11-24)<br>See claims 1, 2 (line 1, second compound) and 3-13; and table 1. | 1-4,10-15,17,18 |

Form PCT/ISA/210 (second sheet) (July 2022)

**INTERNATIONAL SEARCH REPORT**
**Information on patent family members**

International application No.
**PCT/KR2023/006432**

| Patent document cited in search report | Publication date (day/month/year) | Patent family member(s) | Publication date (day/month/year) |
|---|---|---|---|
| KR 10-2020-0072407 A | 22 June 2020 | CN 113423862 A | 21 September 2021 |
| | | CN 113423862 B | 09 June 2023 |
| | | JP 2022-511849 A | 01 February 2022 |
| | | JP 7262912 B2 | 24 April 2023 |
| | | KR 10-2021-0070179 A | 14 June 2021 |
| | | KR 10-2521465 B1 | 12 April 2023 |
| | | SG 11202104157 A | 28 May 2021 |
| | | US 2021-0327708 A1 | 21 October 2021 |
| | | WO 2020-122506 A2 | 18 June 2020 |
| | | WO 2020-122506 A3 | 30 July 2020 |
| KR 10-2259874 B1 | 03 June 2021 | None | |
| KR 10-2016-0000392 A | 04 January 2016 | None | |
| US 9045509 B2 | 02 June 2015 | CN 102712662 A | 03 October 2012 |
| | | EP 2464652 A2 | 20 June 2012 |
| | | EP 2810947 A1 | 10 December 2014 |
| | | JP 2013-501815 A | 17 January 2013 |
| | | KR 10-2012-0093165 A | 22 August 2012 |
| | | TW 201114939 A | 01 May 2011 |
| | | TW I496929 B | 21 August 2015 |
| | | US 2012-0207927 A1 | 16 August 2012 |
| | | WO 2011-020042 A2 | 17 February 2011 |
| | | WO 2011-020042 A3 | 09 June 2011 |
| KR 10-2015-0139628 A | 11 December 2015 | CN 101815807 A | 25 August 2010 |
| | | CN 101815807 B | 13 June 2012 |
| | | CN 103147062 A | 12 June 2013 |
| | | EP 2191034 A1 | 02 June 2010 |
| | | EP 2191034 B1 | 13 March 2013 |
| | | JP 2010-539710 A | 16 December 2010 |
| | | KR 10-2010-0072021 A | 29 June 2010 |
| | | TW 200912024 A | 16 March 2009 |
| | | TW I464290 B | 11 December 2014 |
| | | US 2009-0081385 A1 | 26 March 2009 |
| | | US 8039062 B2 | 18 October 2011 |
| | | WO 2009-036046 A1 | 19 March 2009 |
| WO 2022-146668 A1 | 07 July 2022 | TW 202235423 A | 16 September 2022 |
| | | US 2022-0205099 A1 | 30 June 2022 |
| WO 2022-245039 A1 | 24 November 2022 | KR 10-2022-0157741 A | 29 November 2022 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **J. NIINISTÖ et al.** Novel mixed alkylamido-cyclopentadienyl precursors for ALD of $ZrO_2$ thin films. *Journal of Materials Chemistry*, 2008, vol. 18 (43), 5243